# EUROPEAN PATENT APPLICATION

(11) **EP 4 675 678 A1**
(43) Date of publication of application: **07.01.2026**
(21) Application number: 25173400.0
(22) Date of filing: 29.04.2025
(51) Int. Cl.: H01L 23/15, H01L 23/00

(54) **AUTOMATED MANUFACTURING OF HYBRID PANELS**

(30) Priority: 03.06.2024 US 202418732002
(71) Applicant: INTEL Corporation, Santa Clara, CA 95054 (US)
(72) Inventor: WANG, Yekan, Chandler, AZ 85286 (US); JIMENEZ, Andrew Matthew, Mesa, AZ 85210 (US); XIE, Zhixin, Chandler, AZ 85249 (US); KONCHADY, Manohar, Chandler, AZ 85248 (US); PEOPLES, Joseph, Gilbert, AZ 85296 (US); OJEH, Virginia, Phoenix, AZ 85044 (US); ZAMANI, Ehsan, Phoenix, AZ 85048 (US); HAN, Jung Kyu, Chandler, AZ 85226 (US); DUAN, Gang, Chandler, AZ 85248 (US); PIETAMBARAM, Srinivas Venkata Ramanuja, Chandler, AZ 85249 (US); CHAKRAPANI, Nirupama, Chandler, AZ 85249 (US); MANEPALLI, Rahul, Chandler, AZ 85249 (US)
(74) Representative: HGF

(57) **Abstract**

Hybrid panels comprising one or more solid layers of glass positioned within an organic panel are automatically manufactured by a tool link comprising an alignment module, a buffer lamination module, a gap reinforcement module, and a press module. The alignment module places one or more glass layers within an organic frame to form a hybrid panel assembly. The buffer lamination module places a buffer layer on the hybrid panel assembly. The gap reinforcement module places reinforcement material strips over gaps between the frame and the layers of glass and gaps between adjacent layers of glass. Alternatively, the gap reinforcement module dispenses liquid mold material along the gaps. The buffer module performs compression molding on hybrid panel assemblies to form hybrid panels that have planar top and bottom surfaces, and upon which integrated circuit components can be fabricated.

## Description

### BACKGROUND

Panel-level manufacturing allows for the fabrication of integrated circuit components on substrates larger than the 300-millimeter wafer substrates used in modern semiconductor fabrication facilities. Panel-level manufacturing of integrated circuit components also enables the leveraging of existing high-volume panel manufacturing technologies.

The use of glass as a substrate in integrated circuit components is receiving increased attention due to glass having certain advantageous over organic substrates, such as better thermal stability, mechanical stability, and flatness.

### BRIEF DESCRIPTION OF THE DRAWINGS

FIGS. 1A-1C are plan views of example glass layer arrangements within hybrid panels.
FIG. 2 is a cross-sectional view of a first example hybrid panel.
FIG. 3 is a cross-sectional view of a second example hybrid panel.
FIG. 4 is a cross-sectional view of a third example hybrid panel.
FIG. 5 is a cross-sectional view of a fourth example hybrid panel.
FIG. 6 is a cross-sectional view of a fifth example hybrid panel.
FIG. 7 is a cross-sectional view of a sixth example hybrid panel.
FIG. 8 is a cross-sectional view of a seventh example hybrid panel.
FIG. 9 is a cross-sectional view of an eighth example hybrid panel.
FIG. 10 is a cross-sectional view of a ninth example hybrid panel.
FIG. 11 is a block diagram of an example tool link capable of automatically producing hybrid panels.
FIGS. 12A-12G are cross-sectional views of an example hybrid panel assembly as it is manufactured by an example link.
FIGS. 13A-13C are plan views of the example hybrid panel assembly during processing by an alignment module.
FIGS. 14A-14B are plan views of the example hybrid panel assembly during processing by a buffer lamination module.
FIG. 15 is a block diagram of a first example gap reinforcement module.
FIGS. 16A-16E are plan views of the example hybrid panel assembly during processing by a gap reinforcement module.
FIG. 17 is a block diagram of an example press module.
FIG. 18 is a block diagram of a first example gap reinforcement module.
FIGS. 19A-19B illustrate plan and cross-sectional views, respectively, of liquid mold material being dispensed in the frame-glass gap of an example hybrid panel assembly by a gap reinforcement module.
FIG. 20 is a first example method of automatically manufacturing hybrid panels.
FIG. 21 is a second example method of automatically manufacturing hybrid panels.
FIG. 22 is a third example method of automatically manufacturing hybrid panels.
FIG. 23 is a block diagram of an example computing system in which technologies described herein may be implemented.
FIG. 24 is a block diagram of an example processor unit 2400 to execute computer-executable instructions as part of implementing technologies described herein.
FIG. 25 is a cross-sectional side view of an integrated circuit device that may be included in a microelectronic assembly, in accordance with any of the embodiments disclosed herein.
FIG. 26 is a cross-sectional side view of an integrated circuit device assembly that may include a microelectronic assembly, in accordance with any of the embodiments disclosed herein.

### DETAILED DESCRIPTION

The fragile nature of glass presents challenges for its use as a substrate in panel-level manufacturing. The edges of full-sized rectangular glass panels, which can have lengths and widths of up to 600 mm, can be vulnerable to cracking, chipping, and breakage due to frequent contact and handling during processing. Specialized toolsets that are capable of handling and processing glass panels without causing edge damage are not widely available and the development of such tools would likely involve the expenditure of significant tool and manufacturing flow development resources.

Disclosed herein is an automated manufacturing flow (which can be referred to as a "link") for fabricating hybrid panels, which are panels that comprise one or more solid layers of glass positioned within an organic frame. The link automatically produces hybrid panels from organic frames and solid layers of glass that are supplied to the link as input materials. The link comprises an alignment module, a buffer lamination module, a gap reinforcement module, and a press module. The alignment module places one or more solid layers of glass within a frame. The buffer lamination module places a buffer layer over the frame and the layers of glass. The buffer layer covers the gap between the frame and the layers of glass (frame-glass gap) and gaps between adjacent layers of glass (glass gaps). The buffer layer can comprise Ajinomoto Build-up Film (ABF) or other suitable build-up material. The gap reinforcement module places strips of reinforcement material over the frame-glass gap and any glass gaps to provide mechanical reinforcement in the vicinity of the gap regions. Or, a gap reinforcement module can place a layer of reinforcement material over the frame-glass gap and glass gap regions. Alternatively, the gap reinforcement module can dispense liquid phase material along the frame-glass gap and glass gaps. The reinforcement material can comprise glass cloth prepreg material and/or ABF. After a buffer layer and strips (or a layer) of reinforcement material has been placed on one or both sides of the frame and layers of glass, the press module performs double-sided compression molding on the hybrid panel assembly to produce a hybrid panel. Hybrid panels comprising reconstituted layers of glass have planar top and bottom surfaces upon which integrated circuit components can be placed or built. Through-glass vias (TGVs) can be formed in the solid layers of glass of a hybrid panel during an integrated circuit component manufacturing flow. The TGVs can comprise a metal. The through-glass vias can be used to provide an interconnection between components (integrated circuit component, conductive traces) on one side of the hybrid panel to the other side of the hybrid panel.

The technologies disclosed herein have at least the following advantages. First, they provide an automated toolset or link that can convert an organic frame and one or more solid layers of glass (e.g., a single glass panel or multiple glass sub-panels) into a hybrid panel. Second, hybrid panels offer the benefits that glass substrates can provide (e.g., improved flatness, high-temperature tolerance, mechanical stability, and optical signal routing capabilities) in a structure that isolates glass layer edges from handling and processing. This reduces the likelihood of damage to the glass substrates during hybrid panel processing. Third, the hybrid panels can be processed by existing high-volume manufacturing lines that operate on organic panels or substrates. Existing panel handling keep-out zones (KOZs), panel-level Unit Level Traceability (ULT), and Automation Materials Handling System (AMHS) solutions can be leveraged by hybrid panels. Leveraging existing high-volume manufacturing flows with hybrid panels presents an opportunity for cost savings by avoiding spending significant resources on the development of dedicated tools and process flows that operate on frameless glass panels.

In the following description, specific details are set forth, but embodiments of the technologies described herein may be practiced without these specific details. Well-known structures and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact with each other and "coupled" may indicate elements co-operate or interact with each other, but they may or may not be in direct physical or electrical contact. Furthermore, the terms "comprising," "including," "having," and the like, as used with respect to embodiments of the present disclosure, are synonymous.

Terms modified by the word "substantially" include arrangements, orientations, spacings, or positions that vary slightly from the meaning of the unmodified term. For example, a layer that is substantially planar may have bumps, divots, undulations, or other features on a surface of the layer due to process manufacturing variations and/or imperfections; the portion of a first layer or feature that is substantially perpendicular to a second layer or feature can include a first layer or feature that is +/- 20 degrees from the second layer or feature; a first surface that is substantially parallel to a second surface can include a first surface that is within several degrees of parallel from the second surface; and a material that substantially fills a gap can comprise voids in the material. Values modified by the word "about", including values listed as lower and upper limits of a range of values, include values within +/-10% of the listed values.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

Certain terminology may also be used herein for the purpose of reference only, and thus are not intended to be limiting. For example, terms such as "upper," "lower," "above," "below," "bottom," and "top" refer to directions in the Figures to which reference is made. Terms such as "front," "back," "rear," and "side" describe the orientation and/or location of layers, components, portions of components, etc., within a consistent but arbitrary frame of reference, which is made clear by reference to the text and the associated Figures describing the layers, component, portions of components, etc. under discussion. Such terminology may include the words specifically mentioned above, derivatives thereof, and words of similar import.

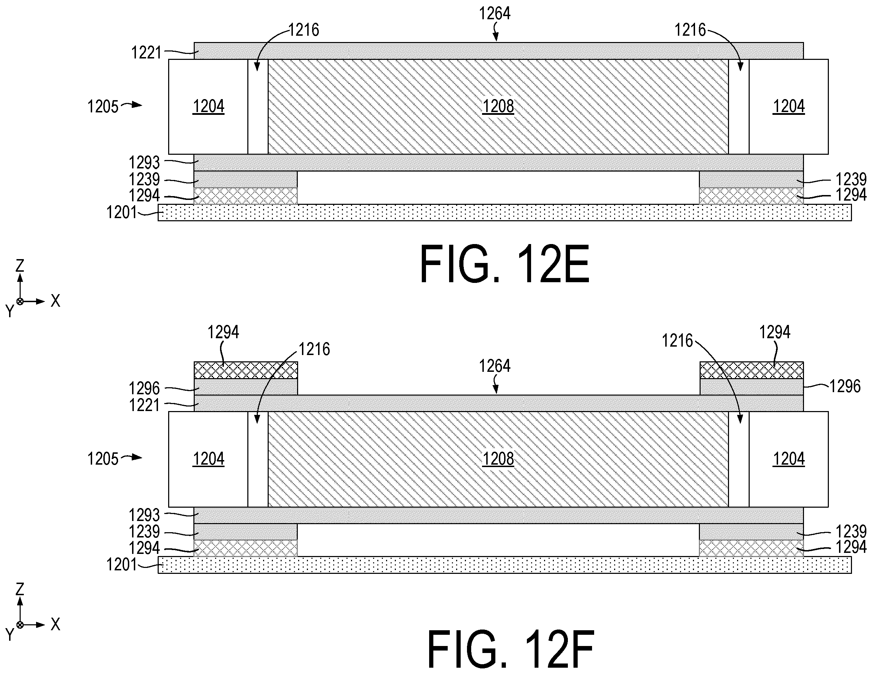

As used herein, the phrase "located on" or "on" in the context of a first layer or component located on or on a second layer or component refers to the first layer or component being directly physically attached to the second part or component (no layers or components between the first and second layers or components) or physically attached to the second layer or component with one or more intervening layers or components. For example, with reference to FIG. 12F, the reinforcement strips 1294 are on a portion of the buffer layer 1221 and a portion of the frame 1204 (with intervening strips of buffer material 1239).

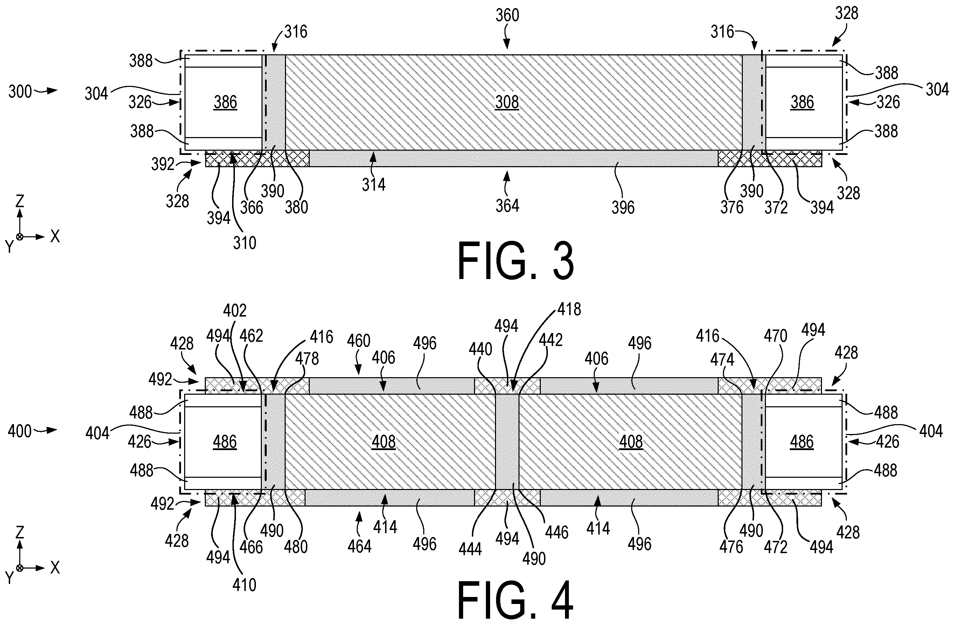

As used herein, the term "adjacent" refers to layers or components that are placed in a side-by-side arrangement. For example, with reference to FIG. 4, layers of glass 408 are adjacent.

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as a metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

Reference is made herein to an "outer extent" of one or more components, such as an outer extent of reinforcement strips or an outer extent of a buffer. As used herein, the term "outer extent" refers to the smallest rectangular boundary that encloses the recited components.

As used herein, the terms "operating", "executing", or "running" as they pertain to software or firmware in relation to a system, device, platform, or resource are used interchangeably and can refer to software or firmware stored in one or more computer-readable storage media accessible by the system, device, platform or resource, even though the software or firmware instructions are not actively being executed by the system, device, platform, or resource.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

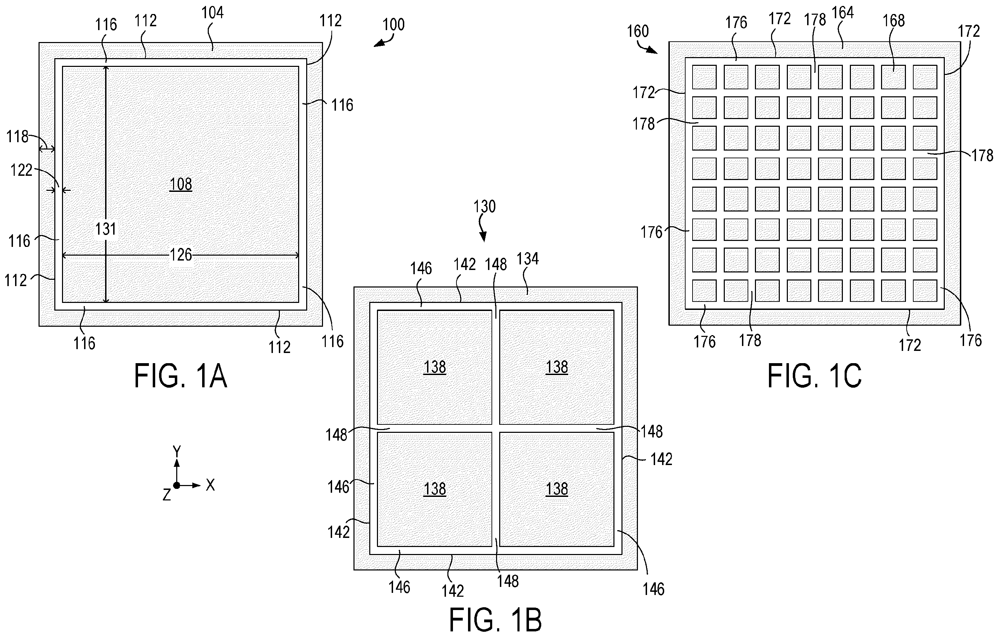

FIGS. 1A-1C are plan views of example glass layer arrangements within hybrid panels. FIGS. 1A, 1B, and 1C illustrate arrangements 100, 130, and 160, respectively. Arrangement 100 comprises a single rectangular solid layer of glass (or glass core, glass substrate) 108 positioned within a rectangular frame 104. The inner faces 112 of the frame 104 are spaced from the solid layer of glass 108 by a gap 116. Arrangement 130 comprises four rectangular solid layers of glass sub-panels (or quarter-panels) 138 positioned within a rectangular frame 134. The inner faces 142 of the frame 134 are spaced from the solid layers of glass 138 by frame-glass gap 146 and adjacent layers of glass are separated by glass gaps 148. Arrangement 160 comprises sixteen rectangular solid layers of glass 168 positioned with a rectangular frame 164. The inner faces 172 of the frame 164 are spaced from the solid layers of glass 168 by gap 176. Adjacent layers of glass are separated by gaps 178.

In some embodiments, the width (e.g., 122) of the frame-glass gap (e.g., 116, 146, 176) and the glass gaps (e.g., 148, 178) can be in a range of about 0.5 to about 10 millimeters. In other embodiments, the width of these gaps can be within other ranges of values. In some embodiments, the frame-glass gap can have the same width along all inner faces of the frame. In other embodiments, the width of a frame-glass gap along one inner face of the frame can be different from the width of the frame-glass gap along any other inner face of the frame. Similarly, in some embodiments, the glass gaps can all have the same width, while in other embodiments, the width of any glass gap can be different from any other glass gap width. The width of any glass gap can be the same as or different from the width of the frame-glass gap. Hybrid panels can have any number of rectangular solid layers of glass (or sub-panels), in addition to the hybrid panels shown with one, four, and sixteen layers of glass illustrated in FIGS. 1A-1C. Conveniently, a hybrid panel can accommodate a wide range of sizes of rectangular glass sub-panels, such as whatever off-the-shelf glass panel size happens to be available from suppliers. In some embodiments, the frame of a hybrid panel can have a width 118 in a range of about five to 15 millimeters. In other embodiments, the frame can have any other width.

Accounting for the widths of the frame and frame-glass gap, a hybrid panel comprising a single layer of glass (e.g., layer 108 illustrated in FIG. 1A) can have a length and width (e.g., length 126 and width 131) slightly less than that of a full-sized panel. Some typical full panel sizes are 18" by 24" (457 mm by 610 mm), 12" by 18" (305 mm by 457 mm), and 9" by 12" (229 mm by 305 mm). In some embodiments, individual solid layers of glass can have dimensions of about 10 mm on a side to about 250 mm on a side. In other embodiments, individual solid layers of glass can have dimensions of about 600 mm or less on a side.

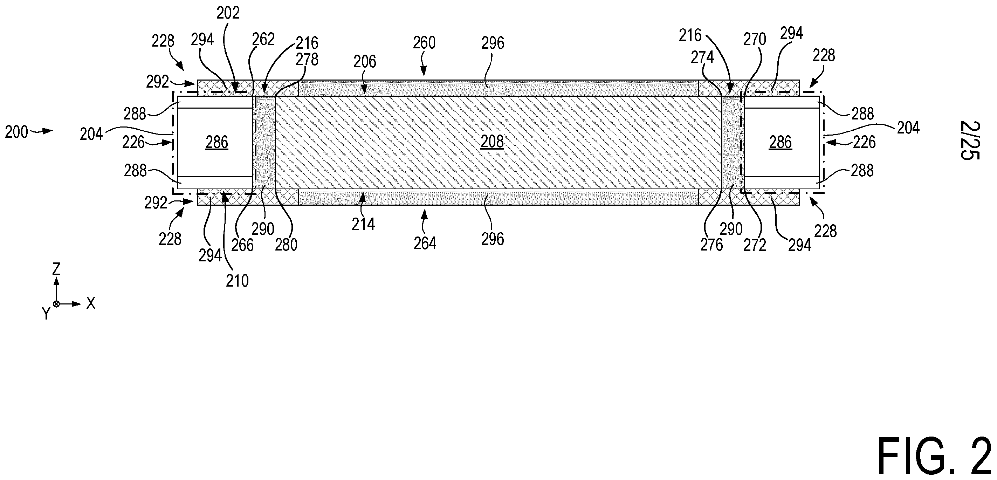

FIG. 2 is a cross-sectional view of a first example hybrid panel. The hybrid panel 200 comprises a frame 204 and a single solid layer of glass 208. The frame 204 is a copper clad laminate comprising an organic frame material 286 positioned between copper layers 288. Gap 216 between the frame 204 and the solid layer of glass 208 is substantially filled with a gap fill material 290. Buffer layers 292 are located on top and bottom sides of the hybrid panel 200. The individual buffer material portions 296 are located on the solid layer of glass 208 and a portion of the frame 204. The individual buffer material portions 296 cover the gap 216 and are substantially planar. The top and bottom surfaces 260 and 264 of the hybrid panel 200 are substantially planar. A top surface 202 of the frame 204 is substantially coplanar with a top surface 206 of the solid layer of glass 208 and a bottom surface 210 of the frame 204 is substantially coplanar with a bottom surface 214 of the solid layer of glass 208.

Individual buffer material portions 296 comprise reinforcement strips 294 that comprise a reinforcement material and a buffer material portion 296 that comprises buffer material. The buffer material portions 296 are positioned between the reinforcement strips 294 and cover a portion of the solid layer of glass 208. The reinforcement strips 294 provide mechanical reinforcement to the hybrid panel 200 in the vicinity of the gap 216. The individual reinforcement strips 294 cover the gap 216 along one inner face of the frame 204 and overlap the frame 204 and the solid layer of glass 208 for a distance. That is, the individual reinforcement strips 294 extend past an edge where the gap 216 meets the frame (e.g., top edges 262 and 270, bottom edges 266 and 272) and further extend past an edge where the gap 216 meets the solid layer of glass (e.g., top edges 274 and 278, bottom edges 276 and 280). With the frame 204 being a rectangular frame with four inner faces, the individual buffer material portions 296 comprises four reinforcement strips 294 - one along each inner face of the frame 204. The hybrid panel 200 further comprises notches 228 along the outer edges of the hybrid panel 200. The notches 228 are due to outer faces 226 of the frame 204 extending past the outer extent of the reinforcement strips 294 on the top and bottom surfaces 260 and 264. As discussed below, the notches are features that are advantageous during compression molding of a hybrid panel assembly.

FIG. 3 is a cross-sectional view of a second example hybrid panel. The hybrid panel 300 comprises a frame 304 and a single solid layer of glass 308. The hybrid panel 300 is similar to the hybrid panel 200 of FIG. 2 but with a buffer layer located only on one side of the hybrid panel 300. The frame 304 is a copper clad laminate comprising an organic frame material 386 positioned between copper layers 388. Gap 316 between the frame and the solid layer of glass 308 is substantially filled with a gap fill material 390. A buffer layer 392 is located on the bottom side of the hybrid panel 300. Top and bottom surfaces 360 and 364, respectfully, of the hybrid panel 300 are substantially planar, with the top surface 360 of the hybrid panel 300 comprising outward-facing surfaces of the solid layer of glass 308 and frame 304. A bottom surface 310 of the frame 304 is substantially coplanar with a bottom surface 314 of the layer of glass 308.

The buffer layer 392 comprises reinforcement strips 394 that comprise a reinforcement material and a portion 396 that comprises buffer material. The portions 396 are positioned between reinforcement strips 394 and cover a portion of the solid layer of glass 308. The individual reinforcement strips 394 cover the gap 316 along one inner face of the frame 304 and overlap the frame 304 and the solid layer of glass 308 for a distance. That is, the individual reinforcement strips 394 extend past an edge where the gap 316 meets the frame (e.g., edges 366, 372) and further extend past an edge where the gap 316 meets the solid layer of glass (e.g., edges 376, 380). With the frame 304 being a rectangular frame with four inner faces, the buffer layer 392 comprises four reinforcement strips 394, one along each inner face of the frame 304. The hybrid panel 300 further comprises notches 328 along the outer edges on the bottom side of the hybrid panel 300. The notches 328 are due to outer faces 326 of the frame 304 extending past the outer extent of the buffer layer 392.

FIG. 4 is a cross-sectional view of a third example hybrid panel. The hybrid panel 400 comprises a frame 404 and four solid layers (or sub-layers, quarter-panels) of glass 408, only two of which are viewable in FIG. 4. The hybrid panel 400 is similar to the hybrid panel 200 of FIG. 2 in that it has buffer layers on its top and bottom sides. The frame 404 is a copper clad laminate comprising an organic frame material 486 positioned between copper layers 488. Gap 416 between the frame 404 and the solid layers of glass 408 and gap 418 between adjacent layers of glass 408 (glass gaps 418) are substantially filled with gap fill material 490. Buffer layers 492 are located on top and bottom surface sides of the hybrid panel 400. Top and bottom surfaces 460 and 464 of the hybrid panel are substantially planar. A top surface 402 of the frame 404 is substantially coplanar with top surfaces 406 of the solid layers of glass 408 and a bottom surface 410 of the frame 404 is substantially coplanar with bottom surfaces 414 of the solid layers of glass 408.

Individual buffer layers 492 comprise reinforcement strips 494 that comprise a reinforcement material and portions 496 that comprise buffer material. Portions 496 are positioned between reinforcement strips 494 and cover a portion of the solid layers of glass 408. The individual reinforcement strips 494 covering the frame-glass gap 416 cover the gap 416 and overlap the frame 404 and the solid layer of glass 408 for a distance. That is, the individual reinforcement strips 494 extend past an edge where the gap 416 meets the frame 404 (e.g., top edges 462 and 470, bottom edges 466 and 472) and further extend past an edge where the gap 416 meets a solid layer of glass (e.g., top edges 474 and 478, bottom edges 476 and 480). Individual reinforcement strips 494 that cover the glass gaps 418 cover a glass gap 418 and extend over a portion of adjacent solid layers of glass 408. That is, the individual reinforcement strips 494 that cover a glass gap 418 extend past edges where the glass gap 418 meets adjacent solid layers of glass 408 (e.g., edges 440, 442, 444, 446). The hybrid panel 400 further comprises notches 428 along the outer edges on the top and bottom sides of the hybrid panel 400. The notches 428 are due to outer faces 426 of the frame 404 extending past the outer extents of the reinforcement strips 494 on the top and bottom surfaces 460 and 464. In some embodiments, a hybrid panel comprising multiple solid layers of glass comprises a buffer layer on only its top or bottom side.

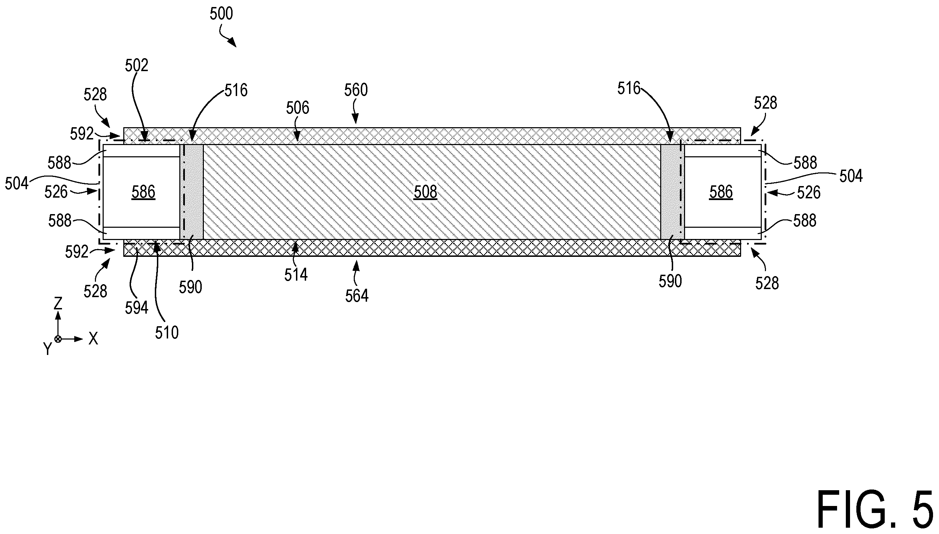

FIG. 5 is a cross-sectional view of a fourth example hybrid panel. The hybrid panel 500 comprises a frame 504 and a single layer of glass layer. The hybrid panel 500 is similar to the hybrid panel 200 of FIG. 2, but with buffer layers comprising a layer of reinforcement material instead of strips of reinforcement material with buffer material portions comprising buffer material positioned between the reinforcement strips. The frame 504 is a copper clad laminate comprising an organic frame material 586 positioned between copper layers 588. The gap 516 is substantially filled with a gap fill material 590. Buffer layers 592 are located on top and bottom sides of the hybrid panel 500. Top and bottom surfaces 560 and 564 of the hybrid panel 500 are substantially planar. A top surface 502 of the frame 504 is substantially coplanar with a top surface 506 of the solid layer of glass 508 and a bottom surface 510 of the frame 504 is substantially coplanar with a bottom surface 514 of the solid layer of glass 508. The buffer layer 592 comprises reinforcement material and provides mechanical reinforcement for the hybrid panel 500 in the vicinity of the gap 516 as well as over the layer of glass 508. The hybrid panel 500 further comprises notches 528 along the outer edges of the hybrid panel 500. The notches 528 are due to outer faces 526 of the frame 504 extending past the outer extents of the reinforcement strips 594 on the surfaces 560 and 564.

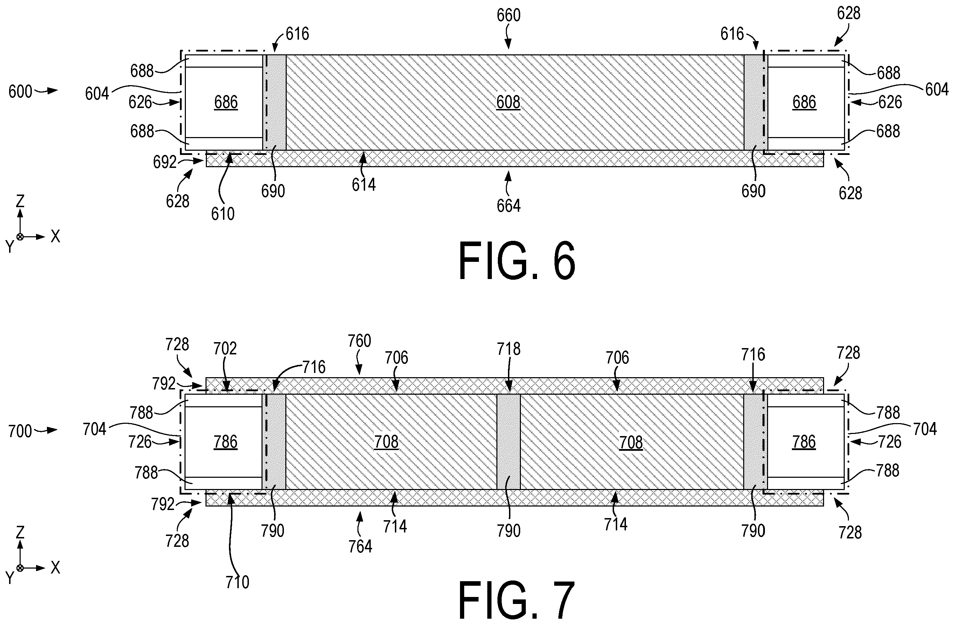

FIG. 6 is a cross-sectional view of a fifth example hybrid panel. The hybrid panel 600 comprises a frame 604 and a single solid layer of glass 608. The hybrid panel 600 is similar to the hybrid panel 500 of FIG. 5 but with a buffer layer located on only one side of the hybrid panel. The frame 604 is a copper clad laminate comprising an organic frame material 686 positioned between copper layers 688. Gap 616 between the frame 604 and the solid layer of glass 608 is substantially filled with gap fill material 690. A buffer layer 692 is located on the bottom side of the hybrid panel 600. Top and bottom surfaces 660 and 664, respectfully, of the hybrid panel 600 are substantially planar, with the top surface 660 of the hybrid panel 600 comprising outward-facing surfaces of the solid layer of glass 608 and frame 604. A bottom surface 610 of the frame 604 is substantially coplanar with a bottom surface 614 of the solid layer of glass 608. The buffer layer 692 comprises reinforcement material and provides mechanical reinforcement for the hybrid panel 600 in the vicinity of the gap 616 as well as along the layer of glass 608. The hybrid panel 600 further comprises notches 628 along the outer edges of the hybrid panel 600. The notches 628 are due to outer faces 626 of the frame 604 extending past the outer extent of the buffer layer 692.

FIG. 7 is a cross-sectional view of a sixth example hybrid panel. The hybrid panel 700 comprises a frame 704 and four solid layers of glass 708, only two of which are viewable in FIG. 7. The hybrid panel 700 is similar to the hybrid panel 500 of FIG. 5 in that it has buffer layers on its top and bottom sides. The frame 704 is a copper clad laminate comprising an organic frame material 786 positioned between copper layers 788. Frame-glass gap 716 and glass gap 718 are substantially filled with gap fill material 790. Buffer layers 792 are located on top and bottom sides of the hybrid panel 700. A bottom surface 764 and a top surface 760 of the hybrid panel 700 are substantially planar. A top surface 702 of the frame 704 is substantially coplanar with top surfaces 706 of the solid layers of glass 708 and a bottom surface 710 of the frame 704 is substantially coplanar with bottom surfaces 714 of the solid layers of glass 708. The buffer layer 792 comprises reinforcement material and provides mechanical reinforcement for the hybrid panel 700 in the vicinity of the frame-glass gap 716, the glass gap 718, as well as along the layers of glass 708. The hybrid panel 700 further comprises notches 728 along the outer edges of the hybrid panel 700. The notches 728 are due to outer faces 726 of the frame 704 extending past the outer extents of the buffer layers 792 on the surfaces 760 and 764. In other embodiments, a hybrid panel comprising multiple layers of glass comprises a buffer layer on only its top or bottom side.

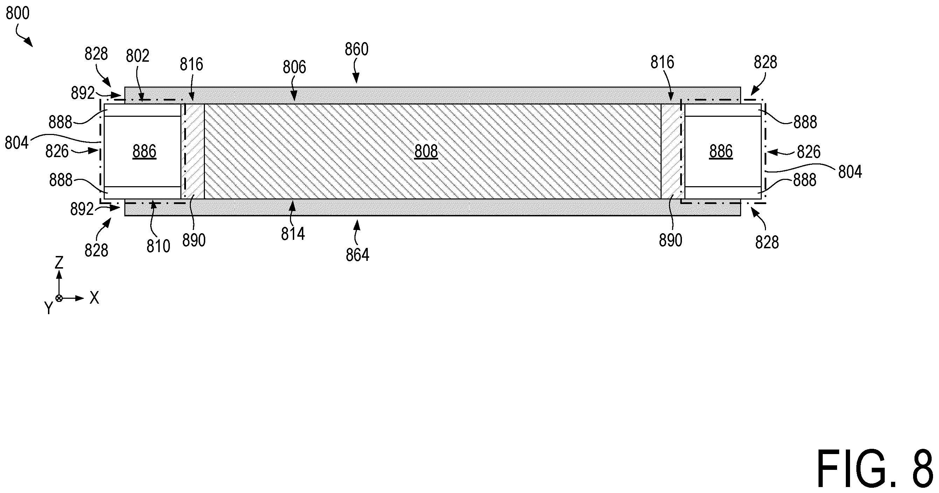

FIG. 8 is a cross-sectional view of a seventh example hybrid panel. The hybrid panel 800 comprises a frame 804 and a single solid layer of glass 808. The hybrid panel 800 is similar to the hybrid panels 200 and 400 of FIGS. 2 and 4 but with buffer layers comprised entirely of buffer material instead of being composed either entirely or partially of reinforcement material. The frame 804 is a copper clad laminate comprising an organic frame material 886 positioned between copper layers 888. The gap 816 is substantially filled with a liquid mold material 890. Buffer layers 892 are located on top and bottom sides of the hybrid panel 800. The top and bottom surfaces 860 and 864 are substantially planar. A top surface 802 of the frame 804 is substantially coplanar with a top surface 806 of the solid layer of glass 808 and a bottom surface 810 of the frame 804 is substantially coplanar with a bottom surface 814 of the solid layer of glass 808. The buffer layer 892 comprises buffer material. The hybrid panel 800 further comprises notches 828 along the outer edges of the hybrid panel 800. The notches 828 are due to outer faces 826 of the frame 804 extending past the outer extents of the buffer layers 892 on the surfaces 860 and 864.

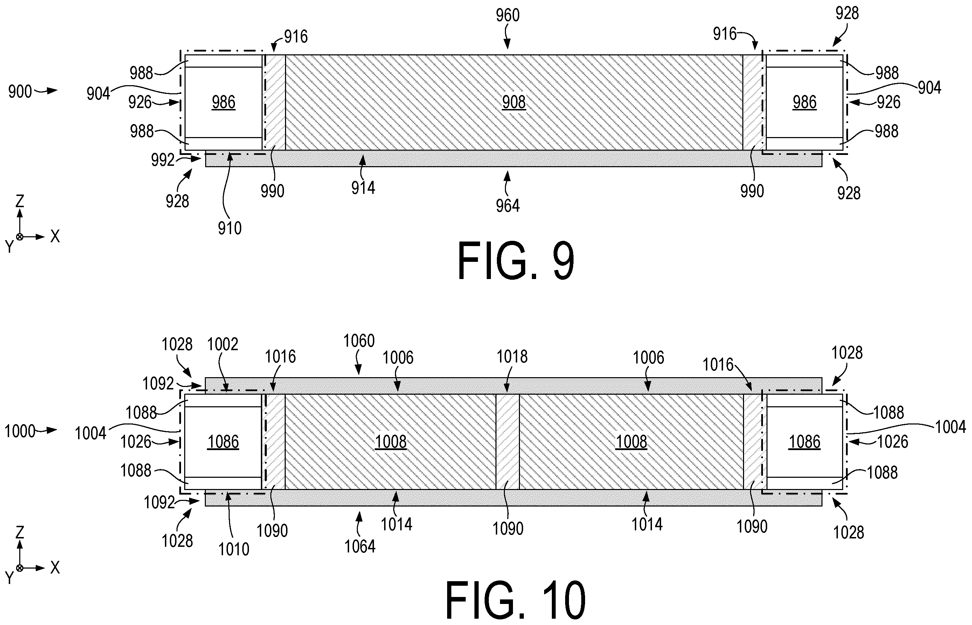

FIG. 9 is a cross-sectional view of an eighth example hybrid panel. The hybrid panel 900 comprises a frame 904 and a single solid layer of glass 908. The hybrid panel 900 is similar to the hybrid panel 800 of FIG. 8 but with a buffer layer located on only one side of the hybrid panel. The frame 904 is a copper clad laminate comprising an organic frame material 986 positioned between copper layers 988. Frame-glass gap 916 between is substantially filled with a liquid mold material 990. A buffer layer 992 is located on the bottom of the hybrid panel 900. Top and bottom surfaces 960 and 964, respectfully, of the hybrid panel 900 are substantially planar, with the top surface 960 of the hybrid panel 900 comprising outward-facing surfaces of the solid layer of glass 908, gap 916, and frame 904. A bottom surface 910 of the frame 904 is substantially coplanar with a bottom surface 914 of the solid layer of glass 908. The buffer layer 992 comprises reinforcement material and provides mechanical reinforcement for the hybrid panel 900 in the vicinity of the gap 916 as well as along the layer of glass 908. The hybrid panel 900 further comprises notches 928 along the outer edges of the hybrid panel 900. The notches 928 are due to outer faces 926 of the frame 904 extending past the outer extent of the buffer layer 992.

FIG. 10 is a cross-sectional view of a ninth example hybrid panel. The hybrid panel 1000 comprises a frame 1004 and four solid layers of glass 1008, only two of which are viewable in FIG. 10. The hybrid panel 1000 is similar to the hybrid panel 800 of FIG. 8 in that it has buffer layers on its top and bottom sides. The frame 1004 is a copper clad laminate comprising an organic frame material 1086 positioned between copper layers 1088. Frame-glass gap 1016 and glass gap 1018 are substantially filled with liquid mold material 1090. Buffer layers 1092 are located on top and bottom sides of the hybrid panel 1000. Top and bottom surfaces 1060 and 1064, respectfully, of the hybrid panel 1000 are substantially planar. A top surface 1002 of the frame 1004 is substantially coplanar with top surfaces 1006 of solid layers of glass 1008 and a bottom surface 1010 of the frame 1004 is substantially coplanar with bottom surfaces 1014 of the solid layers of glass 1008. The buffer layer 1092 comprises reinforcement material and provides mechanical reinforcement for the hybrid panel 1000 in the vicinity of the frame-glass gap 1016, glass gap 1018, as well as along the layers of glass 1008. The hybrid panel 1000 further comprises notches 1028 along the outer edges of the hybrid panel 1000. The notches 1028 are due to outer faces 1026 of the frame 1004 extending past the outer extents of the buffer layers 1092 on the surface 1064. In other embodiments, the hybrid panel 1000 comprises a buffer layer on only its top or bottom side.

In any of the hybrid panels described herein, a solid layer of glass can have a thickness in a range of about 0.5 microns to about 1.4 millimeters, in a range of about 25 microns to about 50 microns, of less than about 1.5 millimeters, of greater than 1.5 millimeters, within any other suitable range, or of any other suitable value.

In any of the hybrid panels described herein, a solid layer of glass can comprise silica (silicon dioxide, SiO₂); fused (non-crystalline) silica; aluminosilicate glass (glass comprising silicon-oxygen-aluminum linkages); borosilicate glass (glass comprising silica and boron oxide (B₂O₃)); alumino-borosilicate glass (glass comprising silica, boron oxide, and aluminum oxide (Al₂O₃)); an alkali-free alkaline-earth glass (a glass not comprising an alkali metal (e.g., Li, Na, K) and comprising an oxide of an alkaline earth metal (e.g., magnesium oxide (MgO), calcium oxide (CaO), strontium oxide (SrO), barium oxide (BaO)); an alkaline earth glass (a glass comprising an alkaline earth metal (e.g., Mg, Ca, Sr, Ba)); one or more of the following additives: aluminum oxide, barium oxide, magnesium oxide, calcium oxide, strontium oxide, barium oxide, tin oxide (SnO₂), sodium oxide (Na₂O), potassium oxide (K₂O), lead oxide (e.g.,P₂O₃), zirconium oxide (ZrO₂), lithium oxide (LiO₂), titanium, and zinc; a glass comprising silicon, oxygen, and one or more of the following: aluminum, boron, magnesium, calcium, barium, tin, sodium, potassium, strontium, phosphorous, zirconium, lithium, titanium, and zinc; or silicon and at least one other element (e.g., SiX).

In any of the hybrid panels described herein, a solid layer of glass can comprise at least 23 percent silicon and at least 26 percent oxygen by weight; or at least 23 percent silicon, at least 26 percent oxygen, and at least 5 percent aluminum by weight. In any of the hybrid panels described herein, a solid layer of glass does not comprise an organic adhesive or an organic material. In any of the hybrid panels described herein, a solid layer of glass can be amorphous.

In any of the hybrid panels described herein, the solid layer of glass can have a rectangular shape in plan view. In any of the hybrid panels described herein, the solid layer of glass can comprise a rectangular prism volume. In any of the hybrid panels described herein, the solid layer of glass can comprise a rectangular prism volume having a first side and a second side perpendicular to the first side, the first side having a length in a range of about 10 millimeters to about 250 millimeters and the second side having a length in a range of about 10 millimeters to 250 millimeters. In any of the hybrid panels described herein, the solid layer of glass can comprise a rectangular prism volume having a first side and a second side perpendicular to the first side, the first side having a length of about 600 millimeters or less and the second side having a length in a range of about 600 millimeters or less.

In any of the embodiments described herein, the organic frame material (e.g., 286, 386) can be woven fiberglass cloth impregnated with epoxy resin (e.g., FR-4) or any other suitable organic material (that is, any other suitable material comprising carbon and hydrogen).

In any of the embodiments described herein, the gap fill material can comprise Ajinomoto Build-up Film (ABF), glass cloth prepreg (a layer of woven fiberglass cloth impregnated with a thermosetting resin), epoxy, or liquid mold material. ABF can be characterized as a material predominantly comprising carbon or a material predominantly comprising carbon as well as comprising nitrogen. Glass cloth prepreg material comprises a layer of woven fiberglass cloth impregnated with a thermosetting resin. The fiberglass in the glass cloth prepreg comprises fibers comprising silicon and oxygen. The thermosetting resin can comprise a polymer resin.

In any of the embodiments comprising a liquid mold material as the gap file material, the liquid mold material can comprise a thermosetting resin (comprising carbon and oxygen; or carbon, hydrogen, and oxygen) that can optionally comprise various inorganic fillers to increase the strength of the liquid mold material, such as silica particles (particles comprising silicon and oxygen), glass fibers (fibers comprising silicon and oxygen), or alumina glass fibers (fibers comprising silicon, oxygen, and aluminum).

In any of the embodiments described herein, the buffer material can be ABF or another suitable build-up material (e.g., epoxy resin (such as bismaleimide triazine resin), thermoplastic polyimide, thermosetting polyimide). In any of the embodiments described herein, the reinforcement material can be glass cloth prepreg or another suitable material.

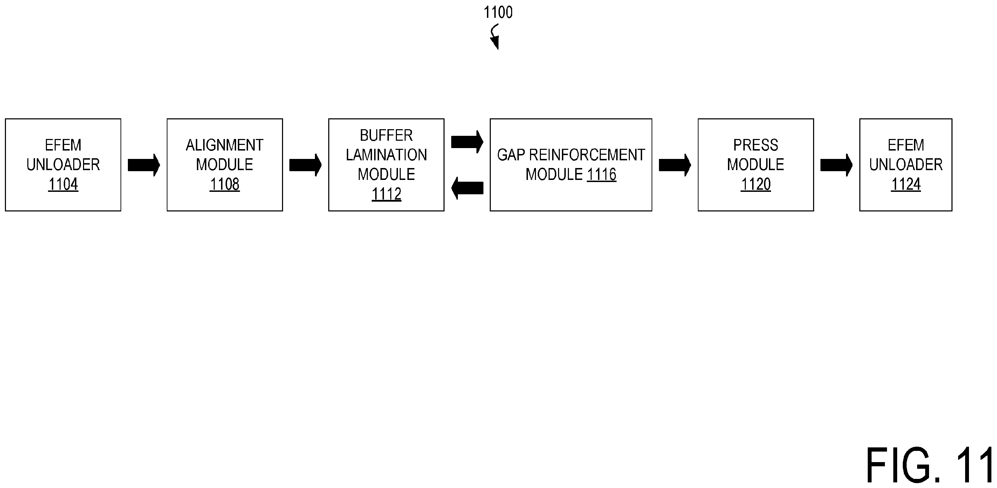

FIG. 11 is a block diagram of an example tool link capable of automatically producing hybrid panels. The tool link (or link) 1100 automatically manufactures hybrid panels from organic frames and solid layers of glass received as input components to the link 1100. The manufacture of hybrid panels is automatic in that there is no user handling of hybrid panel assemblies during fabrication of the hybrid panels. The link 1100 comprises an equipment front-end module (EFEM) loader 1104, an alignment module 1108, a buffer lamination module 1112, a gap reinforcement module 1116, a press module 1120, and an EFEM unloader 1124. The link 1100 comprises a toolset of one or more manufacturing tools with each tool incorporating one or more of the modules illustrated in FIG. 11. The link 1100 further comprises a transport system to transport components (frames, solid layers of glass), hybrid panel assemblies, and hybrid panels to, from, and between modules. The transport system can comprise conveyors, robots, an automated overhead hoist transport (OHT) system, and/or other suitable transport mechanisms.

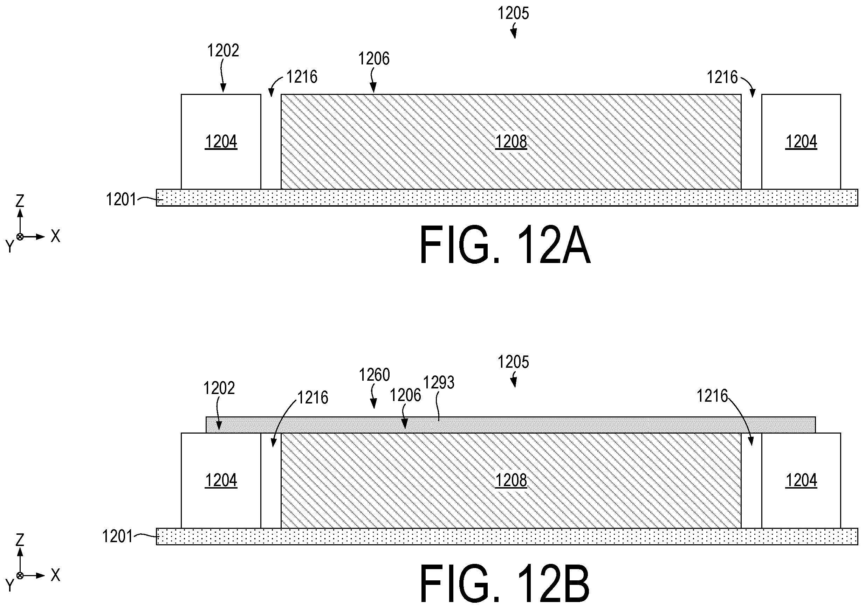

The operation of the link 1100 is discussed with reference to FIGS. 12A-12G, which illustrate cross-sectional views of an example hybrid panel assembly 1205 as it is manufactured by the link 1100. As used herein, the term "hybrid panel assembly" refers to a structure under fabrication by the link at any point during processing by the link that ultimately becomes a hybrid panel. The hybrid panel produced by the example process illustrated in FIGS. 12A-12G is of the hybrid panel type illustrated in FIG. 2. That is, it comprises a single solid layer of glass, buffer layers on its top and bottom sides, and reinforcement strips over the frame-glass gap.

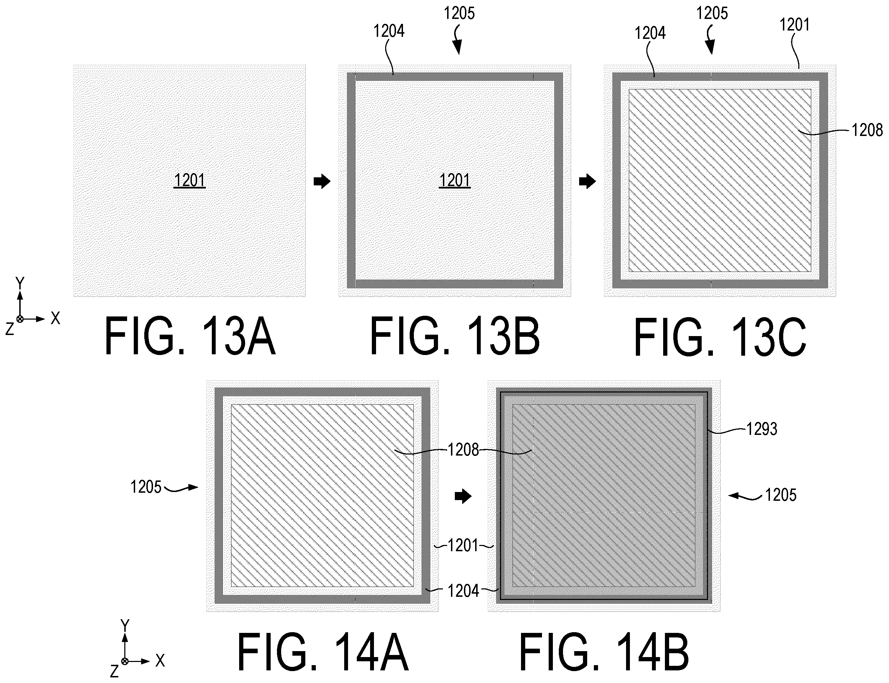

The EFEM loader 1104 receives frames and solid layers of glass and loads alignment module 1108 with the frames and solid layers of glass. FIGS. 13A-13C are plan views of the example hybrid panel assembly during processing by an alignment module. The alignment module 1108 can align layers of glass with the frame using high-accuracy pick and place tools. The alignment mechanism employed by the alignment module 1108 can comprise fiducial-based pneumatic drive micro-positioning of the glass layer and/or the frame, guide pin or guide roller-based self-alignment, a mechanical pusher that pushes the layers of glass or the frame, or another suitable mechanism.

FIG. 13A illustrates the start of the hybrid panel fabrication process with a blank carrier 1201. The carrier used during fabrication of a hybrid panel can comprise glass, silicon, metal, or other suitable material. FIG. 13B illustrates the hybrid panel assembly 1205 after placement of a rectangular frame 1204 on the carrier 1201. FIG. 13C illustrates the hybrid panel assembly1205 after a single solid layer of glass 1208 is placed on the carrier 1201 and positioned within the frame 1204. The relative position of the layer of glass 1208 to the frame 1204 can be fixed after placement of the layer of glass 1208 on the carrier 1201 and alignment to the frame 1204.

FIG. 12A is a cross-sectional view of the example hybrid panel assembly after processing by alignment module 1108. The hybrid panel assembly 1205 illustrated in FIG. 12A comprises frame 1204 and single solid layer of glass 1208 placed on the carrier 1201. The solid layer of glass 1208 is positioned within the frame 1204 with a gap 1216 between the frame 1204 and the solid layer of glass 208. A top surface 1202 of the frame 1204 can be substantially coplanar with a top surface 1206 of the solid layer of glass 1208.

FIGS. 14A-14B are plan views of the example hybrid panel assembly during processing by a buffer lamination module 1112. FIG. 14A illustrates the hybrid panel assembly 1205 received by the buffer lamination module 1112, the hybrid panel assembly 1205 comprising the frame 1204 and the solid layer of glass 1208 placed on the carrier 1201. FIG. 14B illustrates the hybrid panel assembly 1205 after a buffer layer 1293 has been placed on the layer of glass 1208 and a portion of the frame 1204. In some buffer lamination module embodiments, the buffer lamination module comprises a roll laminator with alignment sensors to ensure buffer layers (e.g., ABF sheets) are aligned and stick to the frame and solid layers of glass.

FIG. 12B is a cross-sectional view of the example hybrid panel assembly 1205 after placement of a first buffer layer on the hybrid panel assembly by buffer lamination module 1112. The hybrid panel assembly 1205 illustrated in FIG. 12B comprises frame 1204 and the single solid layer of glass 1208 placed on the carrier 1201. The solid layer of glass 1208 is positioned within the frame 1204 with gap 1216 between the frame 1204 and the solid layer of glass 208. The buffer layer 1293 is located on a top side of the hybrid panel assembly 1205, on the top surface 1206 of the solid layer of glass 1208, and a portion of a top surface 1202 of the frame 1204. A top surface 1260 of the hybrid panel assembly 1205 (a top surface of the buffer layer 1293) is substantially planar.

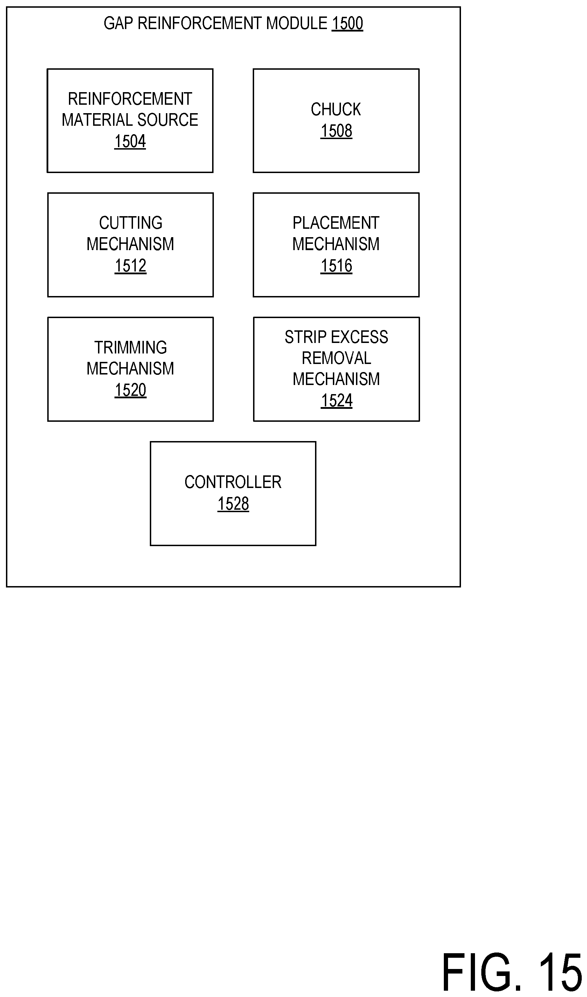

FIG. 15 is a block diagram of a first example gap reinforcement module. The gap reinforcement module 1500 comprises a reinforcement material source 1504, a wafer chuck 1508, a cutting mechanism 1512, a placement mechanism 1516, a trimming mechanism 1520, a strip excess removal mechanism 1524, and a controller 1528. The wafer chuck 1508 holds a hybrid panel assembly in place while it is being processed by the gap reinforcement module 1500. The wafer chuck 1508 can be rotatable. A cutting mechanism 1512 can cut individual reinforcement strips from the reinforcement material source 1504. The cutting mechanism can comprise a cutting edge, such as a knife, or another suitable cutting mechanism, such as a laser. The reinforcement material source 1504 can be a roll, a sheet, or any other suitable form that the reinforcement material can take in bulk. In some embodiments, the reinforcement material source can comprise a single layer of reinforcement material. In other embodiments, the reinforcement material source can comprise a first layer comprising reinforcement material and a second layer comprising buffer material, the first layer positioned on the second layer.

The placement mechanism places reinforcement strips over the frame-glass gap of a hybrid panel assembly along inner edges of the frame. In some embodiments, the placement mechanism can further place reinforcement strips over glass gaps. The placement mechanism can comprise any suitable mechanism that can grab a reinforcement strip, move the reinforcement strip to a desired location with a high degree of precision, and let go of the reinforcement strip. In some embodiments, the placement mechanism can comprise an articulated robot with one or more joints. The placement mechanism can grab and release a reinforcement strip with suction cups, pincers, or another suitable mechanism.

The trimming mechanism 1520 can trim a reinforcement strip after placement of a reinforcement strip on a hybrid panel assembly. The trimming mechanism 1520 can comprise a cutting edge (e.g., a knife) or other suitable trimming mechanism, such as a laser. The strip excess removal mechanism 1524 can remove reinforcement strip excess after a reinforcement strip is trimmed. In some embodiments, the strip excess removal mechanism 1524 can comprise any suitable mechanism that can grab a reinforcement strip excess, move the reinforcement strip excess to a desired location, and let go of the reinforcement strip excess. In some embodiments, the strip excess removal mechanism 1524 can comprise an articulated robot with one or more joints. The strip excess removal mechanism 1524 can grab and release a reinforcement strip excess with suction cups, pincers, or another suitable mechanism. In some embodiments, the cutting mechanism and the trimming mechanism are the same mechanism.

The controller 1528 controls the cutting mechanism, the placement mechanism, the trimming mechanism, the strip excess removal mechanism, and the rotation of the chuck. The controller 1528 further controls the cutting mechanism 1512, the placement mechanism 1516, the trimming mechanism 1520, and the rotation of the chuck 1508 to cause four reinforcement strips to be placed over the frame-glass gap in a hybrid panel assembly (one strip placed over the frame-glass gap along each of the four inner edges of the rectangular frame). The controller 1528 causes the chuck 1508 to rotate ninety degrees between placement of reinforcement strips.

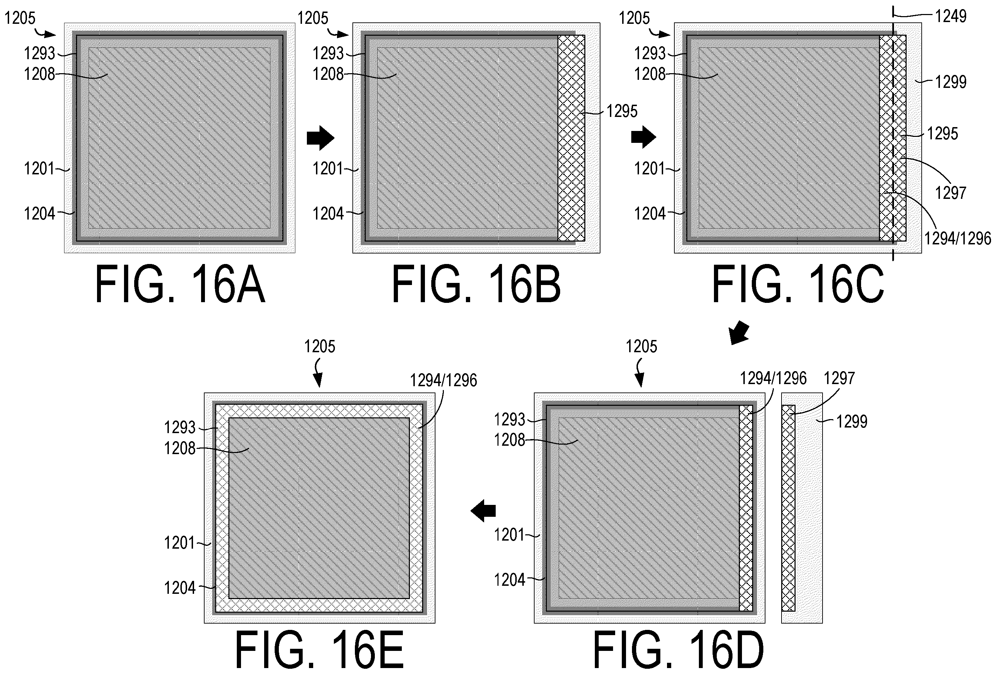

FIGS. 16A-16E are plan views of the example hybrid panel assembly during processing by the gap reinforcement module 1116. FIG. 16A is a plan view of the hybrid panel assembly 1205 received by the gap reinforcement module 1116 comprising the frame 1204 and the layer of glass 1208 placed on the carrier 1201, and a buffer layer 1293 placed on the top side of the hybrid panel assembly 1205. FIG. 16B is a plan view of the hybrid panel assembly 1205 after a reinforcement strip 1295 has been cut by the gap reinforcement module from a reinforcement material source and placed on the hybrid panel assembly 1205 over the frame-glass gap along one inner edge of the frame 1204. The reinforcement strip 1295 comprises a first layer of reinforcement material (e.g., glass cloth prepreg) located on a second layer of buffer material (e.g., ABF) The reinforcement strip 1295 overlaps one edge of the frame 1204 and a portion of the carrier 1201.

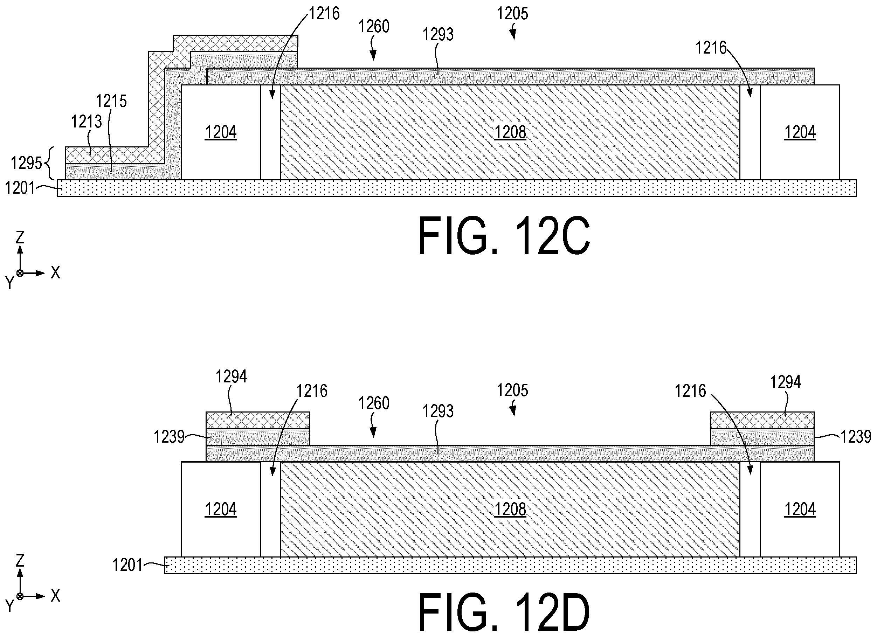

FIG. 12C is a cross-sectional view of the example hybrid panel assembly 1205 after placement of the reinforcement strip 1295 on the hybrid panel assembly 1205 by the gap reinforcement module 1116. The hybrid panel assembly 1205 illustrated in FIG. 12C is the hybrid panel assembly 1205 of FIG. 12B with the addition of the reinforcement strip 1295 placed along one of the edges of the frame 1204. The reinforcement strip 1295 comprises a layer of buffer material 1215 and a layer of reinforcement material 1213, the layer of buffer material 1215 positioned between the layer of reinforcement material 1213 and the carrier 1201. The reinforcement strip 1295 covers the gap 1216 along an inner edge of the frame, a portion of the solid layer of glass 1208, a portion of the frame 1204, and a portion of the carrier 1201.

Returning to FIGS. 16A-16E, FIG. 16C is a plan view of the hybrid panel assembly 1205 after the reinforcement strip 1295 is trimmed along a frame edge (cut line 1249) to create a reinforcement strip 1294, a strip of buffer material 1239, reinforcement strip excess 1297, and carrier excess 1299. FIG. 16D is a plan view of the hybrid panel assembly 1205 with the reinforcement strip excess 1297, and the carrier excess 1299 separated from the hybrid panel assembly 1205. The reinforcement strip 1294 and the strip of buffer material 1239 cover the frame-glass gap 1216 along one inner edge of the frame 1204, are located on a portion of a top face of the frame 1204, and a portion of a top face of the solid layer of glass 1208. FIG. 16E is a plan view of the hybrid panel assembly 1205 resulting from placing a reinforcement strip, trimming the reinforcement strip, and separating the reinforcement strip and carrier excesses for the other three inner edges of the hybrid panel assembly. The gap reinforcement module 1116 is capable of rotating the hybrid panel assembly by 90 degrees between reinforcement strip placements. In embodiments where the reinforcement material source comprises pad film, the gap reinforcement module 1116 can be capable of removing the pad film from placed reinforcement strips.

FIG. 12D is a cross-sectional view of the hybrid panel assembly after placement of reinforcement strips over the frame-glass gap along all four edges inner edges of the frame. The hybrid panel assembly 1205 illustrated in FIG. 12C is the hybrid panel assembly 1205 of FIG. 12E with reinforcement strips placed and trimmed along all four inner edges of the frame 1204, leaving a stack of reinforcement strips 1294 and strips of buffer material 1239 that cover the gap 1216, a portion of the solid layer of glass 1208, and a portion of the frame 1204.

The placing of reinforcement strips and trimming them after placement can allow for easier handling of reinforcement strips by a gap reinforcement module. That is, it may be easier for the gap reinforcement module to cut a wider reinforcement strip from a roll, sheet, or other reinforcement material source and place the wider reinforcement strip in a desired location than to cut a narrower reinforcement strip having a desired final width and place the narrower reinforcement strip at the desired location. In some embodiments, gap reinforcement modules are able to cut and place reinforcement strips having a desired final width with no trimming of the reinforcement strips after they are placed on a hybrid panel assembly. In other embodiments, the gap reinforcement module places and cuts strips comprising just reinforcement material. That is, the strips that are cut, placed, and trimmed by the gap reinforcement module do not comprise buffer material. For example, with reference FIG. 12D, in such embodiments, the strip of buffer material 1239 would be absent and the reinforcement strips 1294 would be positioned against the buffer layer 1293.

After placement and trimming of the reinforcement strips 1294 and the strip of buffer material 1239, the hybrid panel assembly 1205 is returned to the buffer lamination module 1112 to have a buffer strip placed on a second side of the hybrid panel assembly 1205. Prior to placement of the second buffer layer on the hybrid panel assembly 1205, the hybrid panel assembly 1205 is separated from the carrier 1201, flipped, and reattached to the carrier 1201. Alternatively, the flipped hybrid panel assembly can be attached to a different carrier. The separation of the hybrid panel assembly from the carrier 1201, flipping of the hybrid panel assembly, and reattachment of the hybrid panel assembly to a carrier could be performed by the gap reinforcement module 1116, the buffer lamination module 1112, or another module that is part of the link. Separation of the hybrid panel assembly from a carrier during hybrid panel assembly production can be aided by the presence of a release layer positioned between the hybrid panel assembly and the carrier. The release layer is placed on the carrier prior to placement of the hybrid panel assembly on the carrier.

FIG. 12E is a cross-sectional view of the example hybrid panel assembly 1205 after the placement of a second buffer layer on the hybrid panel assembly by the buffer lamination module 1112. The hybrid panel assembly 1205 illustrated in FIG. 12E is the hybrid panel assembly 1205 of FIG. 12D after separation of the hybrid panel assembly 1205 from the carrier 1201, flipping of the hybrid panel assembly 1205, reattachment of the hybrid panel assembly 1205 to the carrier 1201, and placement of the second buffer layer on the hybrid panel assembly 1205. The second buffer layer 1221 covers the gap 1216, the solid layer of glass 1208, and a portion of the frame 1204. Outward-facing surface 1264 of the hybrid panel assembly 1205 (outward-facing surface of the buffer layer 1221) is substantially planar.

After placement of the second buffer layer 1221 on the hybrid panel assembly, the hybrid panel assembly 1205 is returned to the gap reinforcement module 1116 for placement of reinforcement strips and buffer material strips on the second side of the hybrid panel assembly to provide further mechanical reinforcement to the hybrid panel assembly 1205.

FIG. 12F is a cross-sectional view of the hybrid panel assembly 1205 after the placement of reinforcement strips on a second side of the hybrid panel assembly 1205 by the gap reinforcement module 1116. The hybrid panel assembly 1205 illustrated in FIG. 12F is the hybrid panel assembly 1205 of FIG. 12E after the cutting, placement and trimming of reinforcement strips (comprising additional reinforcement strips 1294 and strip of buffer material 1239) along all four inner edges of a side second of the rectangular frame. The added reinforcement strips 1294 and buffer material strips cover the gap 1216, a portion of the solid layer of glass 1208, and a portion of the frame 1204. After buffer layers and reinforcement layers have been placed on both sides of the hybrid panel assembly 1205, the hybrid panel assembly 1205 is transported to the press module 1120.

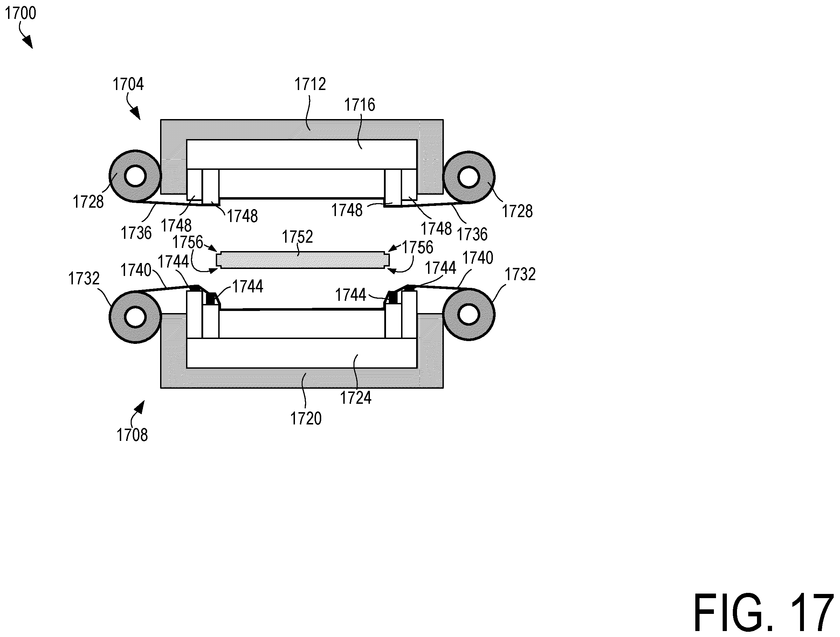

FIG. 17 is a block diagram of an example press module. The press module 1700 is a compression mold tool with release film capabilities on both top and bottom chases for double-sided compression molding in a single step. The press module 1700 comprises a top chase 1704 and a bottom chase 1708. Top chase 1704 comprises a mold base 1712 and a chase assembly 1716, and bottom chase 1708 comprises a mold base 1720 and a chase assembly 1724. Top and bottom film loaders 1728 and 1732 load release films 1736 and 1740 for top and bottom chases 1704 and 1708, respectively. Guide pins 1744 of bottom chase 1708 mate with counterpart features 1748 in top chase 1704 to align the top chase 1704 to the bottom chase 1708 during compression. Compression molding of a hybrid panel assembly can, for hybrid panel assemblies comprising buffer material covering frame-glass gaps (and glass gaps), force buffer material into the gaps, the buffer material forced into the gaps becoming gap filler material (e.g., 290, 590, 890). Compression molding of hybrid panel assemblies typically occurs at an elevated temperature to cure the buffer material and gap fill material, and to cause the buffer material to become more viscous, making it easier for the buffer material to fill the frame-glass and glass gaps.

In some embodiments of the tool link 1100, the press module 1120 can be the press module 1700. In other embodiments, the press module in an automated tool link to produce hybrid panels can comprise any other module or tool that can press a hybrid panel assembly to form a hybrid panel. Regardless of whatever form the press module takes, the press module limits the ability of the frame of a hybrid panel assembly to expand as it is being pressed. The press module can limit the ability of a frame to expand while a hybrid panel assembly is being pressed by, for example, clamping the frame during pressing or by placing the frame in a jig or other feature during pressing. In embodiments where the hybrid panel assembly comprises notches (e.g., 228, 528, 828), the press module clamps onto the frame in one or more places where the frame extends past the notches. Constraining the ability of the frame to expand during pressing of a hybrid panel assembly can provide the advantages of helping buffer material to flow into flame-glass and glass gaps, ensuring that the hybrid panels produced by the press module have a specific size (length and width) that is compatible with downstream tool flows; and minimizing warpage.

A hybrid panel assembly 1752 is illustrated between the top and bottom chases 1704 and 1708 to illustrate the utility of notches 1756 located along the outer edges of the hybrid panel assembly 1752. The notches 1756 allow the hybrid panel assembly 1752 to be clamped during compression, which can prevent buffer material from flowing outside of the compression mold. The clamping enabled by the notches 1756 further allows the solid layer of glass and the frame of the hybrid panel assembly to maintain vertical alignment.

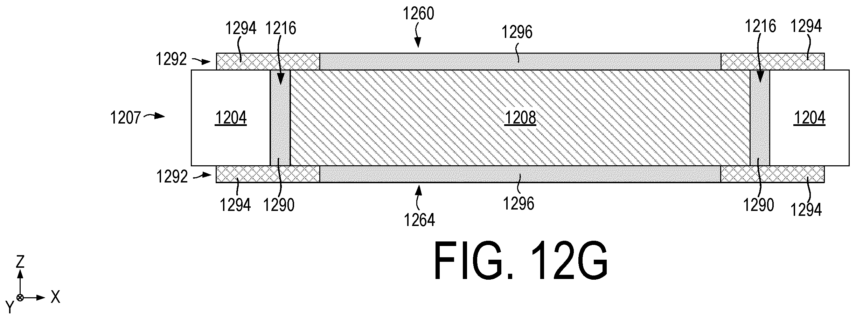

FIG. 12G is a cross-sectional view of a hybrid panel produced by the tool link illustrated in FIG. 11 after compression molding of the example hybrid panel assembly 1205 illustrated in FIG. 12F. The hybrid panel 1207 illustrated in FIG. 12G is the hybrid panel assembly 1205 illustrated in FIG. 12F after being subjected to compression molding. Some of the buffer material of buffer layers 1221 and 1293 of FIG. 12F as well as possibly buffer material portion 1296 has been forced into the gap 1216, becoming gap fill material 1290. As a resulting of the compression molding, the reinforcement strips and the buffer layers and strips located on the top and bottom sides of the hybrid panel assembly are compressed into a single buffer layer 1292 on the top and bottom sides. The individual buffer layers 1292 have substantially planar outward-facing surfaces (surfaces 1260 and 1264) and comprise reinforcement strips 1294 covering the gap 1216 and extending over a portion of the frame 1204 and a portion of the solid layer of glass 1208, and a buffer material portion 1296 positioned between the reinforcement strips 1294. Any hybrid panel assembly located on a carrier can be separated from the carrier prior to being subjected to compression molding.

After compression molding of a hybrid panel assembly by the press module 1120, the hybrid panel is removed from the press module 1120 and the EFEM unloader 1124 unloads the hybrid panel from the link 1100. The EFEM unloader can provide the hybrid panels for handling by an operator or to a conveyor or other transport mechanism to deliver the hybrid panels to another tool or tool link.

The operation of the link 1100 has been described in the context of producing hybrid panels of the type illustrated in FIGS. 2 and 12G - having a single solid layer of glass and buffer layers on top and bottom sides of the hybrid panel with reinforcement strips over the frame-glass gap. In other embodiments, a link can automatically produce hybrid panels of the types illustrated in FIGS. 3-10.

To produce a hybrid panel of the type illustrated in FIG. 3, a hybrid panel comprising reinforcement strips over the frame-glass gap and a buffer layer in between the reinforcement strips on only the top or bottom side of the hybrid panel assembly, a hybrid panel assembly would pass through the buffer lamination module and the gap reinforcement module only once. Once a buffer layer and reinforcement strips are placed on one side of a hybrid panel assembly, such as the hybrid panel assembly illustrated in FIG. 12D, the hybrid panel assemblywould be sent to the press module to produce the hybrid panel.

To produce a hybrid panel of the type illustrated in FIG. 4, a hybrid panel comprising multiple solid layers of glass and reinforcement strips over the frame-glass gap and glass gaps and buffer layers on the top and bottom sides of the hybrid panel assembly, a hybrid panel assembly would receive two passes through the buffer lamination and gap reinforcement modules (a first pass to place a buffer layer and reinforcement strips on one side of the hybrid panel assembly, and a second pass to place a buffer layer and reinforcement strips on the opposite side of the hybrid panel assembly). In addition to cutting, placing, and trimming reinforcement strips over the frame-glass gap, the gap reinforcement module would place reinforcement strips over the glass gaps. In some embodiments, the gap reinforcement module would not trim the reinforcement strips over the glass gaps after placement, while in other embodiments, the reinforcement strips placed over the glass gaps would be trimmed after placement.

To produce a hybrid panel of the type illustrated in FIG. 5, a hybrid panel comprising a single solid layer of glass and layers of reinforcement material covering the frame-glass gap, the solid layer of glass, and a portion of the frame on both top and bottom surfaces of the hybrid panel assembly, in some embodiments, a hybrid panel assembly would receive two passes through the buffer lamination module and the gap reinforcement module (one pass through the buffer lamination module and the gap reinforcement module to place the buffer layer and layer of reinforcement material, respectively, on each of the top and bottom sides of the hybrid panel assembly), before the hybrid panel assembly was passed to the press module. In other embodiments, the buffer lamination module could place a buffer layer on the hybrid panel assembly, followed by placing a layer of reinforcement material on the hybrid panel assembly and the hybrid panel assembly would not be processed by a gap reinforcement module. In still other embodiments, the gap reinforcement module could place a single layer of reinforcement material on the hybrid panel assembly (not a dual-layer reinforcement layer comprising a layer of reinforcement material and a layer of buffer material) on the buffer layer placed by the buffer lamination module.

To produce a hybrid panel of the type illustrated in FIG. 6, a hybrid panel comprising a single solid layer of glass and a layer of reinforcement material over the frame-glass gap, the solid layer of glass, and a portion of the frame on either the top or bottom surface of the hybrid panel assembly, in some embodiments, a hybrid panel assembly would receive one pass through the buffer lamination module and one pass through the gap reinforcement module to place the buffer layer and layer of reinforcement material, respectively, on one side of the hybrid panel assembly, before the hybrid panel assembly was passed to the press module. In other embodiments, the buffer lamination module could place a buffer layer on the hybrid panel assembly, followed by placing a layer of reinforcement material on the hybrid panel assembly and the hybrid panel assembly would not be processed by a gap reinforcement module. In still other embodiments, the gap reinforcement module could place a single layer of reinforcement material (not a dual-layer reinforcement layer comprising a layer of reinforcement material and a layer of buffer material) on the hybrid panel assembly on the buffer layer placed by the buffer lamination module.

To produce a hybrid panel of the type illustrated in FIG. 7, a hybrid panel comprising multiple solid layers of glass and layers of reinforcement material over the frame-glass gap, glass gaps, the solid layers of glass, and a portion of the frame on both top and bottom surfaces on the hybrid panel assembly, in some embodiments, a hybrid panel assembly would receive two passes through the buffer lamination module and the gap reinforcement module (one pass through the buffer lamination module and the gap reinforcement module to place the buffer layer and the layer of reinforcement material, respectively, on each of the top and bottom sides of the hybrid panel assembly), before the hybrid panel assembly was passed to the press module. In other embodiments, the buffer lamination module could place a buffer layer on the hybrid panel assembly, followed by placing a layer of reinforcement material on the hybrid panel assembly and the hybrid panel assembly would not be processed by a gap reinforcement module. In still other embodiments, the gap reinforcement module could place a single layer of reinforcement material (not a dual-layer reinforcement layer comprising a layer of reinforcement material and a layer of buffer material) on the hybrid panel assembly on the buffer layer placed by the buffer lamination module.

To produce a hybrid panel of the type illustrated in FIG. 8, a hybrid panel assembly comprising a single solid layer of glass and a buffer layer over the frame-glass gap, the solid layer of glass, and a portion of the frame on both top and bottom surfaces of the hybrid panel assembly, the frame-glass gap filled with a liquid mold material, the buffer lamination module would place a buffer layer on one side of the hybrid panel assembly, the hybrid panel assembly would then be flipped, and liquid mold material dispensed along the frame-glass gap by the gap reinforcement module. The hybrid panel assembly would then be returned to the buffer lamination module for placement of a buffer layer on the other side of the hybrid panel assembly before the hybrid panel assembly was passed to the press module. In these embodiments, the gap reinforcement module is capable of dispensing liquid mold material along the frame-glass gap. In some embodiments, the gap reinforcement module can dispense the liquid mold material continuously along all four edges of the frame. Alternatively, the gap reinforcement module can rotate the hybrid panel assembly by ninety degrees between applications of liquid mold material along inner edges of the frame.

To produce a hybrid panel of the type illustrated in FIG. 9, a hybrid panel comprising a single solid layer of glass and a buffer layer over the frame-glass gap, the solid layer of glass, and a portion of the frame on either the top or bottom surface of the hybrid panel assembly, the frame-glass gap filled with a liquid mold material, the buffer lamination module would place a buffer layer on one side of the hybrid panel assembly, the hybrid panel assembly would then be flipped, and liquid mold material dispensed along the frame-glass gap by the gap reinforcement module. The hybrid panel assembly would then be passed to the press module.

To produce a hybrid panel of the type illustrated in FIG. 10, a hybrid panel comprising multiple solid layers of glass and buffer layers over the frame-glass gap, glass gaps, the solid layers of glass, and a portion of the frame on both top and bottom surfaces on the hybrid panel assembly, the frame-glass gap filled with a liquid mold material, the buffer lamination module would place a buffer layer on one side of the hybrid panel assembly, the hybrid panel assembly would then be flipped, and liquid mold material dispensed along the frame-glass gap and glass gaps by the gap reinforcement module. The hybrid panel assembly would then be returned to the buffer lamination module for the placement of a buffer layer on the other side of the hybrid panel assembly before the hybrid panel assembly was passed to the press module. In these embodiments, the gap reinforcement module is capable of dispensing liquid mold material along the frame-glass gap and glass gaps.

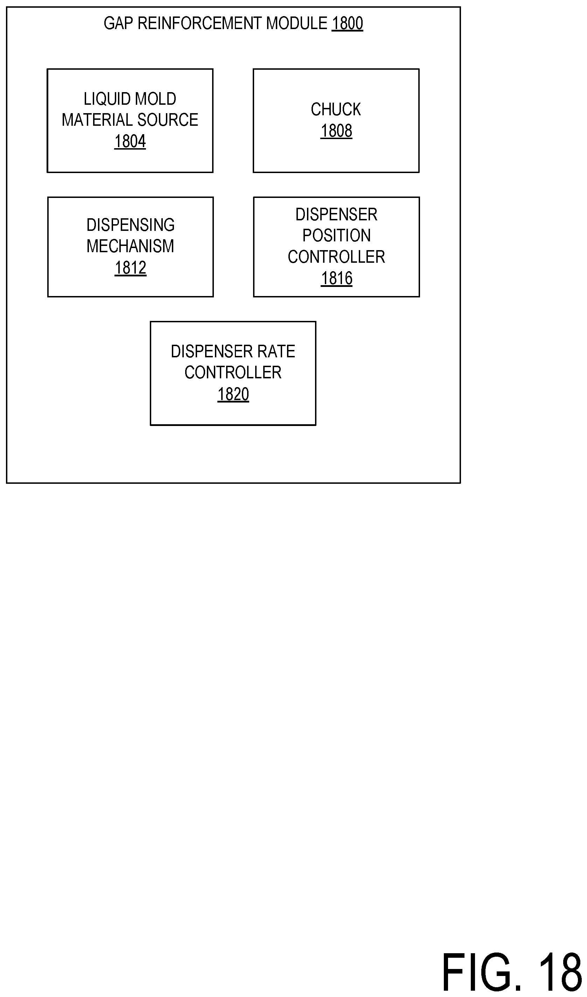

FIG. 18 is a block diagram of a second example gap reinforcement module. The gap reinforcement module 1800 can be used as part of a link that automatically produces hybrid panels of the type illustrated in FIGS. 8-10 (with liquid mold material as the gap fill material). Gap reinforcement module 1800 comprises a liquid mold material source 1804, a wafer chuck 1808, a dispensing mechanism 1812, a dispenser position controller 1816, and a dispenser rate controller 1820. The wafer chuck 1808 holds a hybrid panel assembly in place while it is being processed by the gap reinforcement module 1800. The wafer chuck 1808 may be rotatable. A dispensing mechanism 1812 can dispense liquid mold material from the liquid mold material source 1804 along the frame-glass gap (and glass gaps) of a hybrid panel assembly. The dispensing mechanism can comprise a nozzle, syringe to dispense the liquid mold material or other suitable dispensing mechanism. The dispenser position controller 1816 enables accurate movement and position of the dispensing mechanism and dispenser rate controller 1820 enables adjustment of the liquid mold material dispense rate to account for different liquid mold material viscosities and/or frame-glass gap widths.

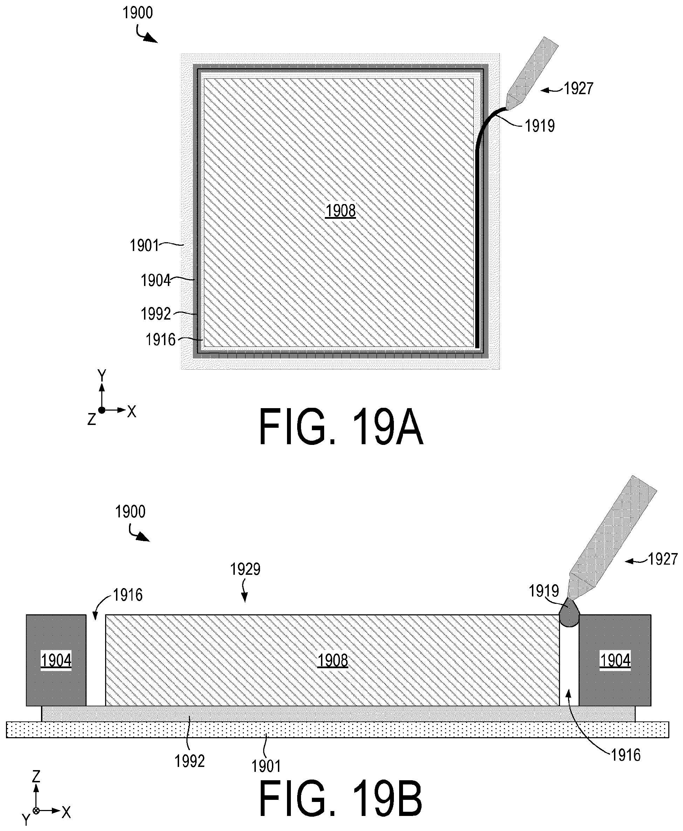

FIGS. 19A-19B illustrate plan and cross-sectional views, respectively, of liquid mold material being dispensed in the frame-glass gap of an example hybrid panel assembly by a gap reinforcement module. The hybrid panel assembly 1900 comprises a frame 1904 and a solid layer of glass 1908 located on a buffer layer 1992, the buffer layer 1992 in turn located on a carrier 1901. The solid layer of glass 1908 is spaced from the frame 1904 by frame-glass gap 1916. Liquid mold material 1919 is shown as being dispensed along an edge of the frame 1904 by a liquid mold dispenser 1927.

The liquid mold material 1919 after being dispensed along the edges of the frame 1904 can be located partially (as shown in FIGS. 19A-19B) or wholly in the gap 1916. The gap 1916 can become substantially filled with the liquid mold material after a second buffer layer 1992 is placed on a top surface 1929 of the hybrid panel assembly 1900 and the hybrid panel assembly 1900 is subjected to compression molding by a press module.

One concern for hybrid panels is their susceptible to warpage (z-height variation across the hybrid panel), due to the different materials used in the panels. Studies of hybrid panels having structures as disclosed herein indicate that they can have a warpage of less than 0.5 mm. Another concern of hybrid panels is gap strength and handling/processing robustness. SEM (scanning electron microscopy) cross-sections of hybrid panels having structures as disclosed herein show no visible voids in the gap regions. Further, test processing of hybrid panels as described herein processed by legacy organic tools such as wet desmear and electroless (e-less) plating (two tools that can have a high risk of damage to frameless glass panels) with recipes comprising mechanical agitation, rock, shock, and vibration showed no signs of edge breakage or delamination, indicating that the hybrid panels as described herein possess promising mechanical robustness.

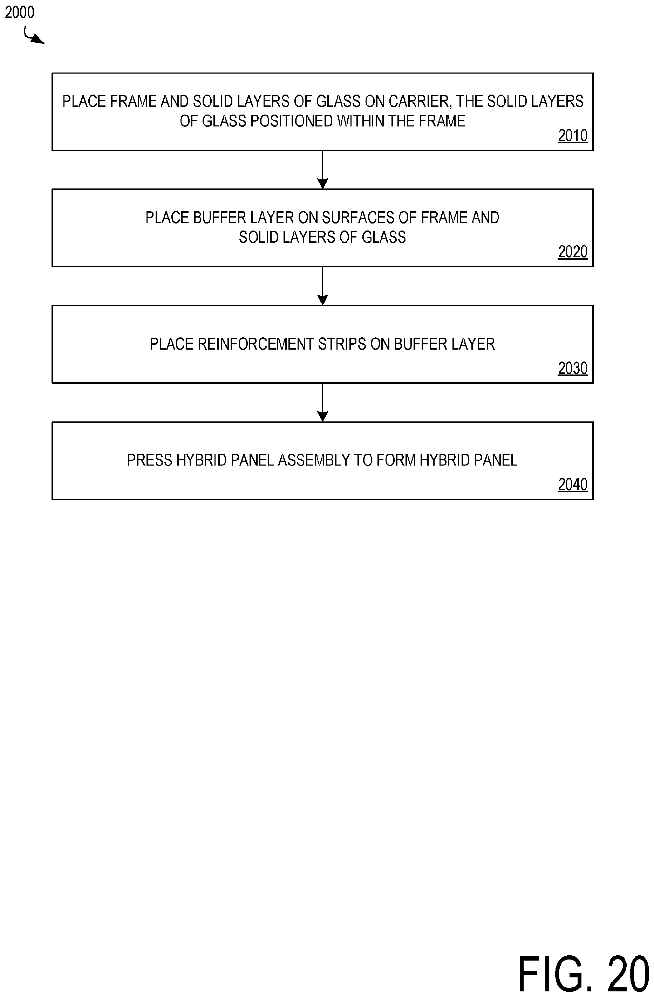

FIG. 20 is a first example method of automatically manufacturing hybrid panels. The method 2000 can be performed by, for example, an integrated circuit component manufacturer. At 2010, a frame and one or more solid layers of glass are placed on a carrier, the one or more solid layers of glass positioned within the frame, a gap located between the frame and the one or more solid layers of glass. At 2020, a buffer layer is placed on a portion of a surface of the frame and one or more surfaces of the one or more solid layers of glass, wherein the buffer layer covers the gap and comprises reinforcement material. At 2030, a plurality of reinforcement strips is placed on the buffer layer, the reinforcement strips comprising reinforcement material, wherein the plurality of reinforcement strips cover the gap, wherein an assembly comprises the frame, the one or more solid layers of glass, and the plurality of reinforcement strips. At 2040, the hybrid panel assembly is pressed in a mold to force buffer layer a portion of the buffer material of the buffer layer into the gap, wherein the assembly, after being pressed, is a hybrid panel having substantially planar top and bottom surfaces.

In other embodiments, the method 2000 can comprise one or more additional elements. For example, the method 2000 can further comprise, wherein the buffer layer is a first buffer layer, the surface of the frame is a first surface of the frame, the one or more surfaces of the one or more solid layers of glass are one or more first surface of the solid layers of glass, placing a second buffer layer on a portion of a second surface of the frame and one or more second surfaces of the one or more solid layers of glass, the frame and the one or more solid layers of glass positioned between the first buffer layer and the second buffer layer, wherein the first buffer layer and the second buffer layer comprise buffer material, wherein the second buffer layer comprises the reinforcement material, wherein the first surface of the frame is opposite to the second surface of the frame and the one or more first surfaces of the one or more solid layers of glass are opposite to the one or more second surfaces of the one or more solid layers of glass.

In another example, placing the plurality of reinforcement strips on the first buffer layer can comprise, for individual reinforcement strips of the plurality of reinforcement strips: cutting an individual reinforcement strip from a reinforcement material source; placing the individual reinforcement strip on the first buffer layer; and trimming the individual reinforcement strip. In another example, placing a plurality of reinforcement strips on the first layer can comprise rotating further comprising rotating the frame by ninety degree between the placement of individual reinforcement strips on the first buffer layer. In yet another embodiment, the method 2000 further comprises, after placing the second buffer layer on the frame and the one or more solid layers of glass, placing a second plurality of reinforcement strips on the second buffer layer, the second plurality of reinforcement strips comprising the reinforcement material, the second plurality of reinforcement strips covering the gap.

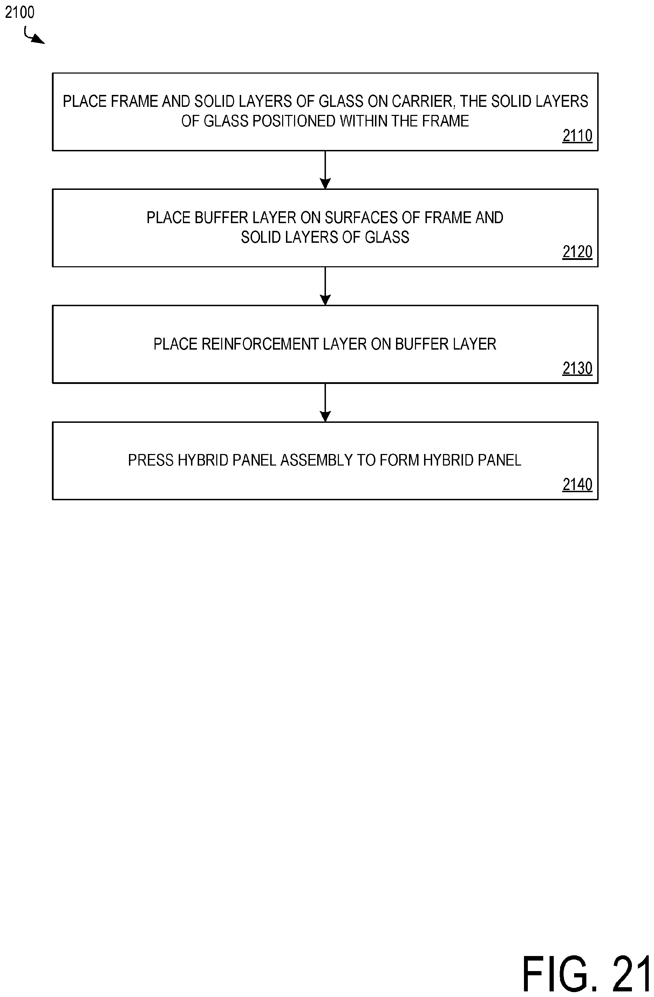

FIG. 21 is a second example method of automatically manufacturing hybrid panels. The method 2100 can be performed by, for example, an integrated circuit component manufacturer. At 2110, a frame and one or more solid layers of glass are placed on a carrier, the one or more solid layers of glass positioned within the frame, a gap located between the frame and the one or more solid layers of glass. At 2120, a buffer layer is placed on a portion of a first surface of the frame and one or more first surfaces of the one or more solid layers of glass, wherein the buffer layer covers the gap and comprises reinforcement material. At 2130, a reinforcement layer is placed on the buffer layer, wherein the reinforcement layer covers the gap and comprises reinforcement material, wherein a hybrid panel assembly comprises the frame, the one or more solid layers of glass, the first buffer layer and the second buffer layer. At 2140, the hybrid panel assembly is pressed in a mold to force a portion of the buffer material of the buffer layer into the gap, wherein the assembly, after being pressed, is a hybrid panel having substantially planar top and bottom surfaces.

In other embodiments, the method 2100 can comprise one or more additional elements. For example, the method 2100 can further comprise, wherein the buffer layer is a first buffer layer, placing a second buffer layer on a portion of a second surface of the frame and one or more second surfaces of the one or more solid layers of glass, the frame and the one or more solid layers of glass positioned between the first buffer layer and the second buffer layer, wherein the second buffer layer comprises the buffer material, wherein the first surface of the frame is opposite to the second surface of the frame and the one or more first surfaces of the one or more solid layers of glass are opposite to the one or more second surfaces of the one or more solid layers of glass. In another example, the method 2100 can further comprise, after placing the second buffer layer on the frame and the one or more solid layers of glass, placing a second reinforcement layer on the second buffer layer, the second reinforcement layer comprising the reinforcement material and covering the gap.

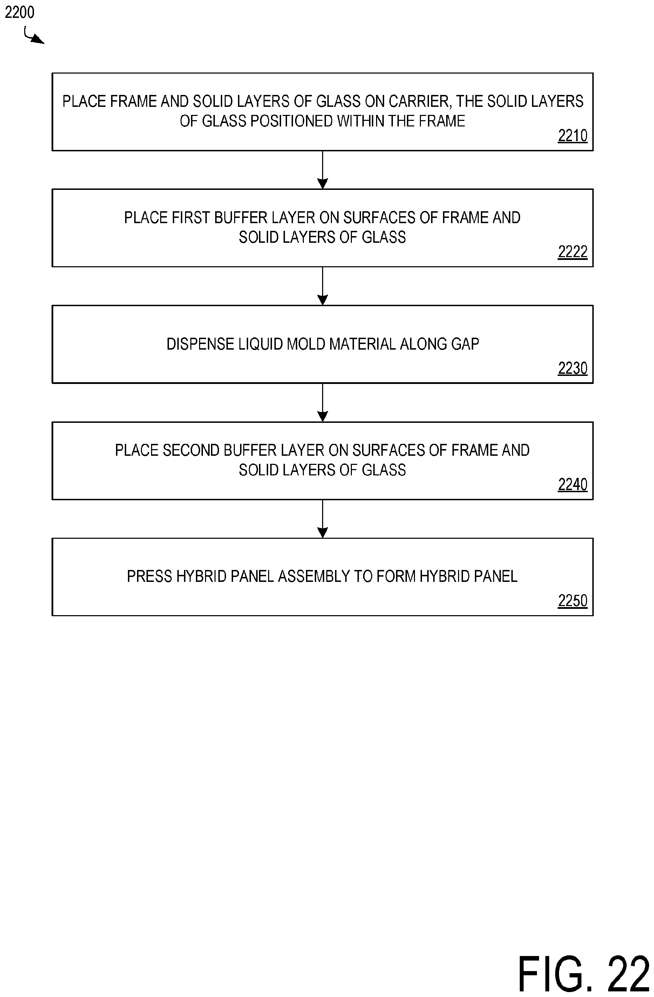

FIG. 22 is a third example method of automatically manufacturing hybrid panels. The method 2200 can be performed by, for example, an integrated circuit component manufacturer. At 2210, a frame and one or more solid layers of glass are placed on a carrier, the one or more solid layers of glass positioned within the frame, a gap located between the frame the one or more solid layers of glass. At 2220, a first buffer layer is placed on a portion of the frame and one or more first surfaces of the one or more solid layers of glass, wherein the buffer layer covers the gap. At 2230, liquid mold material is dispensed along the gap. At 2240, a second buffer layer is placed on a portion of a second surface of the frame and one or more second surfaces of the one or more solid layers of glass, the frame and the one or more solid layers of glass positioned between the first buffer layer and the second buffer layer, wherein an assembly comprises the frame, the one or more solid layers of glass, wherein the first buffer layer and the second buffer layer comprise buffer material, wherein the first surface of the frame is opposite to the second surface of the frame and the one or more first surfaces of the one or more solid layers of glass are opposite to the one or more second surfaces of the one or more solid layers of glass. At 2250, the hybrid assembly is pressed in a mold to force a portion of the buffer material of the first buffer layer into the gap, wherein the assembly, after being pressed, is a hybrid panel having substantially planar top and bottom surfaces.

In other embodiments, the method 2200 can comprise one or more additional elements. For example, the method 2200 can further comprise flipping the frame after dispensing the liquid mold material and before placing the second buffer layer on the portion of the second portion of the frame and the one or more second surfaces of the one or more solid layers of glass.

The modules described herein can perform any portion of hybrid panel manufacture and can comprise a variety of computing systems, including mobile computing systems (e.g., handheld computers, tablet computers, laptop computers, portable all-in-one computers), non-mobile computing systems (e.g., desktop computers, servers, workstations), and embedded computing systems (e.g., computing systems that are part of manufacturing equipment). As used herein, the term "computing system" includes computing devices and includes systems comprising multiple discrete physical components. In some embodiments, the computing systems are located in a data center.

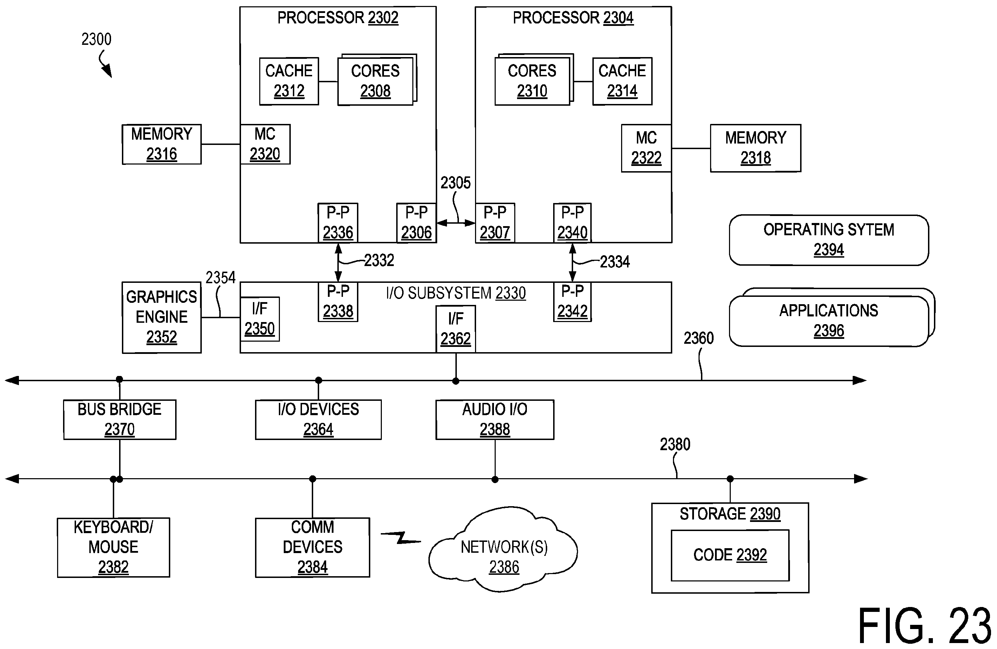

FIG. 23 is a block diagram of an example computing system in which technologies described herein may be implemented. Generally, components shown in FIG. 23 can communicate with other shown components, although not all connections are shown, for ease of illustration. The computing system 2300 is a multiprocessor system comprising a first processor unit 2302 and a second processor unit 2304 comprising point-to-point (P-P) interconnects. A point-to-point (P-P) interface 2306 of the processor unit 2302 is coupled to a point-to-point interface 2307 of the processor unit 2304 via a point-to-point interconnection 2305. It is to be understood that any or all of the point-to-point interconnects illustrated in FIG. 23 can be alternatively implemented as a multi-drop bus, and that any or all buses illustrated in FIG. 23 could be replaced by point-to-point interconnects.

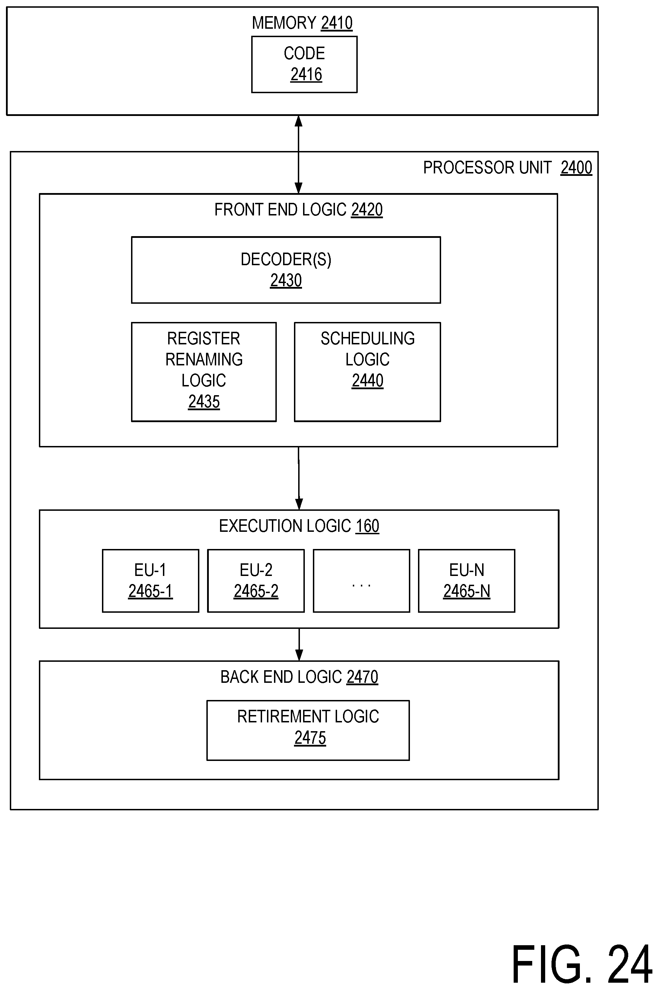

The processor units 2302 and 2304 comprise multiple processor cores. Processor unit 2302 comprises processor cores 2308 and processor unit 2304 comprises processor cores 2310. Processor cores 2308 and 2310 can execute computer-executable instructions in a manner similar to that discussed below in connection with FIG. 24, or other manners.

Processor units 2302 and 2304 further comprise cache memories 2312 and 2314, respectively. The cache memories 2312 and 2314 can store data (e.g., instructions) utilized by one or more components of the processor units 2302 and 2304, such as the processor cores 2308 and 2310. The cache memories 2312 and 2314 can be part of a memory hierarchy for the computing system 2300. For example, the cache memories 2312 can locally store data that is also stored in a memory 2316 to allow for faster access to the data by the processor unit 2302. In some embodiments, the cache memories 2312 and 2314 can comprise multiple cache levels, such as level 1 (L1), level 2 (L2), level 3 (L3), level 4 (L4) and/or other caches or cache levels. In some embodiments, one or more levels of cache memory (e.g., L2, L3, L4) can be shared among multiple cores in a processor unit or among multiple processor units in an integrated circuit component. In some embodiments, the last level of cache memory on an integrated circuit component can be referred to as a last level cache (LLC). One or more of the higher levels of cache levels (the smaller and faster caches) in the memory hierarchy can be located on the same integrated circuit die as a processor core and one or more of the lower cache levels (the larger and slower caches) can be located on an integrated circuit dies that are physically separate from the processor core integrated circuit dies.

Although the computing system 2300 is shown with two processor units, the computing system 2300 can comprise any number of processor units. Further, a processor unit can comprise any number of processor cores. A processor unit can take various forms such as a central processing unit (CPU), a graphics processing unit (GPU), general-purpose GPU (GPGPU), accelerated processing unit (APU), field-programmable gate array (FPGA), neural network processing unit (NPU), data processor unit (DPU), accelerator (e.g., graphics accelerator, digital signal processor (DSP), compression accelerator, artificial intelligence (AI) accelerator), controller, or other types of processing units. As such, the processor unit can be referred to as an XPU (or xPU). Further, a processor unit can comprise one or more of these various types of processing units. In some embodiments, the computing system comprises one processor unit with multiple cores, and in other embodiments, the computing system comprises a single processor unit with a single core. As used herein, the terms "processor unit" and "processing unit" can refer to any processor, processor core, component, module, engine, circuitry, or any other processing element described or referenced herein.

In some embodiments, the computing system 2300 can comprise one or more processor units that are heterogeneous or asymmetric to another processor unit in the computing system. There can be a variety of differences between the processing units in a system in terms of a spectrum of metrics of merit including architectural, microarchitectural, thermal, power consumption characteristics, and the like. These differences can effectively manifest themselves as asymmetry and heterogeneity among the processor units in a system.

Processor units 2302 and 2304 further comprise memory controller logic (MC) 2320 and 2322. As shown in FIG. 23, MCs 2320 and 2322 control memories 2316 and 2318 coupled to the processor units 2302 and 2304, respectively. The memories 2316 and 2318 can comprise various types of volatile memory (e.g., dynamic random-access memory (DRAM), static random-access memory (SRAM)) and/or non-volatile memory (e.g., flash memory, chalcogenide-based phase-change non-volatile memories), and comprise one or more layers of the memory hierarchy of the computing system. While MCs 2320 and 2322 are illustrated as being integrated into the processor units 2302 and 2304, in alternative embodiments, the MCs can be external to a processor unit.

Processor units 2302 and 2304 are coupled to an Input/Output (I/O) subsystem 2330 via point-to-point interconnections 2332 and 2334. The point-to-point interconnection 2332 connects a point-to-point interface 2336 of the processor unit 2302 with a point-to-point interface 2338 of the I/O subsystem 2330, and the point-to-point interconnection 2334 connects a point-to-point interface 2340 of the processor unit 2304 with a point-to-point interface 2342 of the I/O subsystem 2330. Input/Output subsystem 2330 further includes an interface 2350 to couple the I/O subsystem 2330 to a graphics engine 2352. The I/O subsystem 2330 and the graphics engine 2352 are coupled via a bus 2354.

The Input/Output subsystem 2330 is further coupled to a first bus 2360 via an interface 2362. The first bus 2360 can be a Peripheral Component Interconnect Express (PCIe) bus or any other type of bus. Various I/O devices 2364 can be coupled to the first bus 2360. A bus bridge 2370 can couple the first bus 2360 to a second bus 2380. In some embodiments, the second bus 2380 can be a low pin count (LPC) bus. Various devices can be coupled to the second bus 2380 including, for example, a keyboard/mouse 2382, audio I/O devices 2388, and a storage device 2390, such as a hard disk drive, solid-state drive, or another storage device for storing computer-executable instructions (code) 2392 or data. The code 2392 can comprise computer-executable instructions for performing methods described herein. Additional components that can be coupled to the second bus 2380 include communication device(s) 2384, which can provide for communication between the computing system 2300 and one or more wired or wireless networks 2386 (e.g. Wi-Fi, cellular, or satellite networks) via one or more wired or wireless communication links (e.g., wire, cable, Ethernet connection, radio-frequency (RF) channel, infrared channel, Wi-Fi channel) using one or more communication standards (e.g., IEEE 2302.11 standard and its supplements).

In embodiments where the communication devices 2384 support wireless communication, the communication devices 2384 can comprise wireless communication components coupled to one or more antennas to support communication between the computing system 2300 and external devices. The wireless communication components can support various wireless communication protocols and technologies such as Near Field Communication (NFC), IEEE 1002.11 (Wi-Fi) variants, WiMax, Bluetooth, Zigbee, 4G Long Term Evolution (LTE), Code Division Multiplexing Access (CDMA), Universal Mobile Telecommunication System (UMTS) and Global System for Mobile Telecommunication (GSM), and 5G broadband cellular technologies. In addition, the wireless modems can support communication with one or more cellular networks for data and voice communications within a single cellular network, between cellular networks, or between the computing system and a public switched telephone network (PSTN).

The memory in system 2300 (including caches 2312 and 2314, memories 2316 and 2318, and storage device 2390) can store data and/or computer-executable instructions for executing an operating system 2394 and application programs 2396. The system 2300 can also have access to external memory or storage (not shown) such as external hard drives or cloud-based storage.

The operating system 2394 can control the allocation and usage of the components illustrated in FIG. 23 and support the one or more application programs 2396. The application programs 2396 can include common computing system applications (e.g., email applications, calendars, contact managers, web browsers, messaging applications) as well as other computing applications, such a module control application 2397 that can control a function of a module, such the positioning of a frame or a glass layer being placed within a frame in an alignment module, the cutting and placing of a gap reinforcement material strip in a gap reinforcement module, the placement of a buffer layer on a hybrid panel assembly in a buffer alignment module, or pressing of the double-sided mold in a press module.

The computing system 2300 can support various additional input devices, such as a touchscreen, microphone, camera, trackball, touchpad, trackpad, and one or more output devices, such as one or more speakers or displays. Any of the input or output devices can be internal to, external to, or removably attachable with the system 2300. External input and output devices can communicate with the system 2300 via wired or wireless connections.

The system 2300 can further include at least one input/output port comprising physical connectors (e.g., USB, IEEE 1394 (FireWire), Ethernet, RS-232), or a power supply (e.g., battery). The computing system 2300 can further comprise one or more additional antennas coupled to one or more additional receivers, transmitters, and/or transceivers to enable additional functions.

FIG. 24 is a block diagram of an example processor unit 2400 to execute computer-executable instructions as part of implementing technologies described herein. The processor unit 2400 can be a single-threaded core or a multithreaded core in that it may include more than one hardware thread context (or "logical processor") per processor unit.

FIG. 24 also illustrates a memory 2410 coupled to the processor unit 2400. The memory 2410 can be any memory described herein or any other memory known to those of skill in the art. The memory2410 can store computer-executable instructions 2415 (code) executable by the processor unit 2400.

The processor unit comprises front-end logic 2420 that receives instructions from the memory 2410. An instruction can be processed by one or more decoders 2430. The decoder 2430 can generate as its output a micro-operation such as a fixed width microoperation in a predefined format, or generate other instructions, microinstructions, or control signals, which reflect the original code instruction. The front-end logic 2420 further comprises register renaming logic 2435 and scheduling logic 2440, which generally allocate resources and queues operations corresponding to converting an instruction for execution.

The processor unit 2400 further comprises execution logic 2450, which comprises one or more execution units (EUs) 2465-1 through 2465-N. Some processor unit embodiments can include a number of execution units dedicated to specific functions or sets of functions. Other embodiments can include only one execution unit or one execution unit that can perform a particular function. The execution logic 2450 performs the operations specified by code instructions. After completion of execution of the operations specified by the code instructions, back-end logic 2470 retires instructions using retirement logic 2475. In some embodiments, the processor unit 2400 allows out of order execution but requires in-order retirement of instructions. Retirement logic 2475 can take a variety of forms as known to those of skill in the art (e.g., re-order buffers or the like).

The processor unit 2400 is transformed during execution of instructions, at least in terms of the output generated by the decoder 2430, hardware registers and tables utilized by the register renaming logic 2435, and any registers (not shown) modified by the execution logic 2450.

Any of the disclosed methods (or a portion thereof) can be implemented as computer-executable instructions or a computer program product. Such instructions can cause a computing system or one or more processor units capable of executing computer-executable instructions to perform any of the disclosed methods. As used herein, the term "computer" refers to any computing system, device, or machine described or mentioned herein, including semiconductor manufacturing tools, as well as any other computing system, device, or machine capable of executing instructions. Thus, the term "computer-executable instruction" refers to instructions that can be executed by any computing system, device, or machine described or mentioned herein as well as any other computing system, device, or machine capable of executing instructions.

The computer-executable instructions or computer program products as well as any data created and/or used during implementation of the disclosed technologies can be stored on one or more tangible or non-transitory computer-readable storage media, such as volatile memory (e.g., DRAM, SRAM), non-volatile memory (e.g., flash memory, chalcogenide-based phase-change non-volatile memory) optical media discs (e.g., DVDs, CDs), and magnetic storage (e.g., magnetic tape storage, hard disk drives). Computer-readable storage media can be contained in computer-readable storage devices such as solid-state drives, USB flash drives, and memory modules. Alternatively, any of the methods disclosed herein (or a portion) thereof may be performed by hardware components comprising non-programmable circuitry. In some embodiments, any of the methods herein can be performed by a combination of non-programmable hardware components and one or more processing units executing computer-executable instructions stored on computer-readable storage media.

The computer-executable instructions can be part of, for example, an operating system of the computing system, an application stored locally to the computing system, or a remote application accessible to the computing system (e.g., via a web browser). Any of the methods described herein can be performed by computer-executable instructions performed by a single computing system or by one or more networked computing systems operating in a network environment. Computer-executable instructions and updates to the computer-executable instructions can be downloaded to a computing system from a remote server.

Further, it is to be understood that implementation of the disclosed technologies is not limited to any specific computer language or program. For instance, the disclosed technologies can be implemented by software written in C++, C#, Java, Perl, Python, JavaScript, Adobe Flash, C#, assembly language, or any other programming language. Likewise, the disclosed technologies are not limited to any particular computer system or type of hardware.

Furthermore, any of the software-based embodiments (comprising, for example, computer-executable instructions for causing a computer to perform any of the disclosed methods) can be uploaded, downloaded, or remotely accessed through a suitable communication means. Such suitable communication means include, for example, the Internet, the World Wide Web, an intranet, cable (including fiber optic cable), magnetic communications, electromagnetic communications (including RF, microwave, ultrasonic, and infrared communications), electronic communications, or other such communication means.

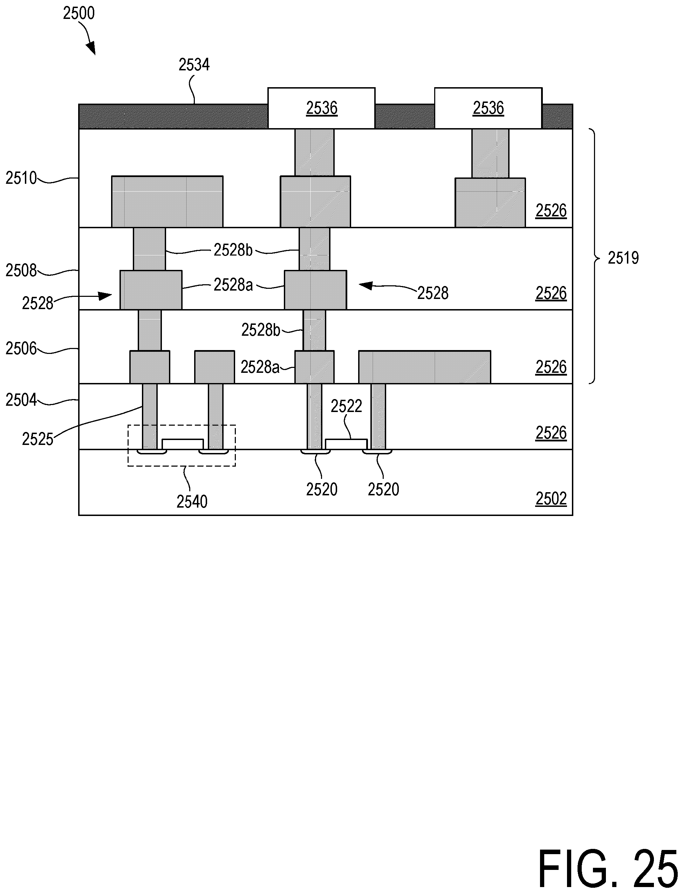

Integrated circuit dies (die) that may be included in any of the microelectronic assemblies disclosed herein that may be positioned on a hybrid panel during hybrid panel processing. The die may include one or more transistors (e.g., some of the transistors 2540 of FIG. 25, discussed below), supporting circuitry to route electrical signals to the transistors, passive components (e.g., signal traces, resistors, capacitors, or inductors), and/or any other integrated circuit components. In some embodiments, the die may include a memory device (e.g., a random access memory (RAM) device, such as a static RAM (SRAM) device, a magnetic RAM (MRAM) device, a resistive RAM (RRAM) device, etc.), a logic device (e.g., an AND, OR, NAND, or NOR gate), or any other suitable circuit element. Multiple ones of these devices may be combined on a single die. For example, a memory array formed by multiple memory devices may be formed on a same die as a processor unit or other logic that is configured to store information in the memory devices or execute instructions stored in the memory array. Various ones of the microelectronic assemblies disclosed herein may be manufactured using a die-to-panel assembly technique in which some dies are attached to a hybrid panel that include others of the dies, and the hybrid panel is subsequently singulated.

FIG. 25 is a cross-sectional side view of an integrated circuit device 2500 that may be included in any of the microelectronic assemblies (e.g., in any of the dies) disclosed herein. The integrated circuit device 2500 may be formed on a die substrate 2502 (e.g., a wafer) and may be included in a die in a microelectronic assembly. The die substrate 2502 may be a semiconductor substrate composed of semiconductor material systems including, for example, n-type or p-type materials systems (or a combination of both). The die substrate 2502 may include, for example, a crystalline substrate formed using a bulk silicon or a silicon-on-insulator (SOI) substructure. In some embodiments, the die substrate 2502 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 2502. Although a few examples of materials from which the die substrate 2502 may be formed are described here, any material that may serve as a foundation for an integrated circuit device 2500 may be used.

The integrated circuit device 2500 may include one or more device layers 2504 disposed on the die substrate 2502. The device layer 2504 may include features of one or more transistors 2540 (e.g., metal oxide semiconductor field-effect transistors (MOSFETs)) formed on the die substrate 2502. The transistors 2540 may include, for example, one or more source and/or drain (S/D) regions 2520, a gate 2522 to control current flow between the S/D regions 2520, and one or more S/D contacts 2524 to route electrical signals to/from the S/D regions 2520. The transistors 2540 may include additional features not depicted for the sake of clarity, such as device isolation regions, gate contacts, and the like. The transistors 2540 are not limited to the type and configuration depicted in FIG. 25 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

A transistor 2540 may include a gate 2522 formed of at least two layers, a gate dielectric and a gate electrode. The gate dielectric may include one layer or a stack of layers. The one or more layers may include silicon oxide, silicon dioxide, silicon carbide, and/or a high-k dielectric material (e.g., hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate).

The gate electrode may be formed on the gate dielectric and may include at least one p-type work function metal or n-type work function metal, depending on whether the transistor 2540 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 2540 along the source-channel-drain direction, the gate electrode may consist of a U-shaped structure that includes a bottom portion substantially parallel to the surface of the die substrate 2502 and two sidewall portions that are substantially perpendicular to the top surface of the die substrate 2502. In other embodiments, at least one of the metal layers that form the gate electrode may simply be a planar layer that is substantially parallel to the top surface of the die substrate 2502 and does not include sidewall portions substantially perpendicular to the top surface of the die substrate 2502. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 2520 may be formed within the die substrate 2502 adjacent to the gate 2522 of individual transistors 2540. The S/D regions 2520 may be formed using an implantation/diffusion process or an etching/deposition process, for example. In the former process, dopants such as boron, aluminum, antimony, phosphorous, or arsenic may be ion-implanted into the die substrate 2502 to form the S/D regions 2520. An annealing process that activates the dopants and causes them to diffuse farther into the die substrate 2502 may follow the ion-implantation process. In the latter process, the die substrate 2502 may first be etched to form recesses at the locations of the S/D regions 2520. An epitaxial deposition process may then be carried out to fill the recesses with material that is used to fabricate the S/D regions 2520. In some implementations, the S/D regions 2520 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 2520 may be formed using one or more alternate semiconductor materials such as germanium or a group III-V material or alloy. In further embodiments, one or more layers of metal and/or metal alloys may be used to form the S/D regions 2520.

Electrical signals, such as power and/or input/output (I/O) signals, may be routed to and/or from the devices (e.g., transistors 2540) of the device layer 2504 through one or more interconnect layers disposed on the device layer 2504 (illustrated in FIG. 25 as interconnect layers 2506-2510). For example, electrically conductive features of the device layer 2504 (e.g., the gate 2522 and the S/D contacts 2524) may be electrically coupled with the interconnect structures 2528 of the interconnect layers 2506-2510. The one or more interconnect layers 2506-2510 may form a metallization stack (also referred to as an "ILD stack") 2519 of the integrated circuit device 2500.

The interconnect structures 2528 may be arranged within the interconnect layers 2506-2510 to route electrical signals according to a wide variety of designs; in particular, the arrangement is not limited to the particular configuration of interconnect structures 2528 depicted in FIG. 25. Although a particular number of interconnect layers 2506-2510 is depicted in FIG. 25, embodiments of the present disclosure include integrated circuit devices having more or fewer interconnect layers than depicted.

In some embodiments, the interconnect structures 2528 may include lines 2528a and/or vias 2528b filled with an electrically conductive material such as a metal. The lines 2528a may be arranged to route electrical signals in a direction of a plane that is substantially parallel with a surface of the die substrate 2502 upon which the device layer 2504 is formed. For example, the lines 2528a may route electrical signals in a direction in and out of the page and/or in a direction across the page from the perspective of FIG. 25. The vias 2528b may be arranged to route electrical signals in a direction of a plane that is substantially perpendicular to the surface of the die substrate 2502 upon which the device layer 2504 is formed. In some embodiments, the vias 2528b may electrically couple lines 2528a of different interconnect layers 2506-2510 together.

The interconnect layers 2506-2510 may include a dielectric material 2526 disposed between the interconnect structures 2528, as shown in FIG. 25. In some embodiments, dielectric material 2526 disposed between the interconnect structures 2528 in different ones of the interconnect layers 2506-2510 may have different compositions; in other embodiments, the composition of the dielectric material 2526 between different interconnect layers 2506-2510 may be the same. The device layer 2504 may include a dielectric material 2526 disposed between the transistors 2540 and a bottom layer of the metallization stack as well. The dielectric material 2526 included in the device layer 2504 may have a different composition than the dielectric material 2526 included in the interconnect layers 2506-2510; in other embodiments, the composition of the dielectric material 2526 in the device layer 2504 may be the same as a dielectric material 2526 included in any one of the interconnect layers 2506-2510.

A first interconnect layer 2506 (referred to as Metal 1 or "M1") may be formed directly on the device layer 2504. In some embodiments, the first interconnect layer 2506 may include lines 2528a and/or vias 2528b, as shown. The lines 2528a of the first interconnect layer 2506 may be coupled with contacts (e.g., the S/D contacts 2524) of the device layer 2504. The vias 2528b of the first interconnect layer 2506 may be coupled with the lines 2528a of a second interconnect layer 2508.

The second interconnect layer 2508 (referred to as Metal 2 or "M2") may be formed directly on the first interconnect layer 2506. In some embodiments, the second interconnect layer 2508 may include via 2528b to couple the lines 2528 of the second interconnect layer 2508 with the lines 2528a of a third interconnect layer 2510. Although the lines 2528a and the vias 2528b are structurally delineated with a line within individual interconnect layers for the sake of clarity, the lines 2528a and the vias 2528b may be structurally and/or materially contiguous (e.g., simultaneously filled during a dual-damascene process) in some embodiments.

The third interconnect layer 2510 (referred to as Metal 3 or "M3") (and additional interconnect layers, as desired) may be formed in succession on the second interconnect layer 2508 according to similar techniques and configurations described in connection with the second interconnect layer 2508 or the first interconnect layer 2506. In some embodiments, the interconnect layers that are "higher up" in the metallization stack 2519 in the integrated circuit device 2500 (i.e., farther away from the device layer 2504) may be thicker that the interconnect layers that are lower in the metallization stack 2519, with lines 2528a and vias 2528b in the higher interconnect layers being thicker than those in the lower interconnect layers.

The integrated circuit device 2500 may include a solder resist material 2534 (e.g., polyimide or similar material) and one or more conductive contacts 2536 formed on the interconnect layers 2506-2510. In FIG. 25, the conductive contacts 2536 are illustrated as taking the form of bond pads. The conductive contacts 2536 may be electrically coupled with the interconnect structures 2528 and configured to route the electrical signals of the transistor(s) 2540 to external devices. For example, solder bonds may be formed on the one or more conductive contacts 2536 to mechanically and/or electrically couple an integrated circuit die including the integrated circuit device 2500 with another component (e.g., a printed circuit board). The integrated circuit device 2500 may include additional or alternate structures to route the electrical signals from the interconnect layers 2506-2510; for example, the conductive contacts 2536 may include other analogous features (e.g., posts) that route the electrical signals to external components.

In some embodiments in which the integrated circuit device 2500 is a double-sided die, the integrated circuit device 2500 may include another metallization stack (not shown) on the opposite side of the device layer(s) 2504. This metallization stack may include multiple interconnect layers as discussed above with reference to the interconnect layers 2506-2510, to provide conductive pathways (e.g., including conductive lines and vias) between the device layer(s) 2504 and additional conductive contacts (not shown) on the opposite side of the integrated circuit device 2500 from the conductive contacts 2536.

In other embodiments in which the integrated circuit device 2500 is a double-sided die, the integrated circuit device 2500 may include one or more through silicon vias (TSVs) through the die substrate 2502; these TSVs may make contact with the device layer(s) 2504, and may provide conductive pathways between the device layer(s) 2504 and additional conductive contacts (not shown) on the opposite side of the integrated circuit device 2500 from the conductive contacts 2536. In some embodiments, TSVs extending through the substrate can be used for routing power and ground signals from conductive contacts on the opposite side of the integrated circuit device 2500 from the conductive contacts 2536 to the transistors 2540 and any other components integrated into the die 2500, and the metallization stack 2519 can be used to route I/O signals from the conductive contacts 2536 to transistors 2540 and any other components integrated into the die 2500.

Multiple integrated circuit devices 2500 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

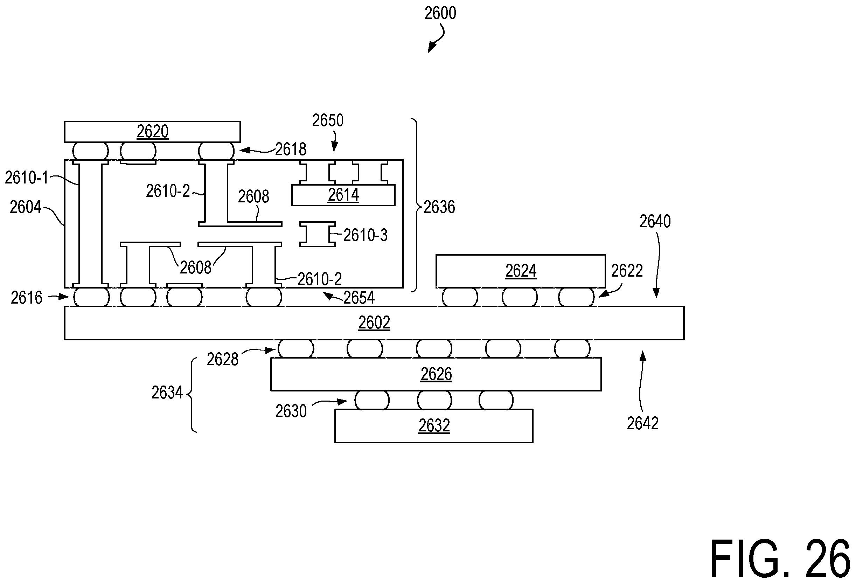

FIG. 26 is a cross-sectional side view of an integrated circuit device assembly 2600 that may include any of the microelectronic assemblies disclosed herein. The integrated circuit device assembly 2600 includes a number of components disposed on a circuit board 2602 (which may be a motherboard, system board, mainboard, etc.). The integrated circuit device assembly 2600 includes components disposed on a first face 2640 of the circuit board 2602 and an opposing second face 2642 of the circuit board 2602; generally, components may be disposed on one or both faces 2640 and 2642. Any of the integrated circuit components discussed below with reference to the integrated circuit device assembly 2600 may take the form of any suitable ones of the embodiments of the microelectronic assemblies disclosed herein.

In some embodiments, the circuit board 2602 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 2602. In other embodiments, the circuit board 2602 may be a non-PCB substrate. The integrated circuit device assembly 2600 illustrated in FIG. 26 includes a package-on-interposer structure 2636 coupled to the first face 2640 of the circuit board 2602 by coupling components 2616. The coupling components 2616 may electrically and mechanically couple the package-on-interposer structure 2636 to the circuit board 2602, and may include solder balls (as shown in FIG. 26), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 2616 may serve as the coupling components illustrated or described for any of the substrate assembly or substrate assembly components described herein, as appropriate.

The package-on-interposer structure 2636 may include an integrated circuit component 2620 coupled to an interposer 2604 by coupling components 2618. The coupling components 2618 may take any suitable form for the application, such as the forms discussed above with reference to the coupling components 2616. Although a single integrated circuit component 2620 is shown in FIG. 26, multiple integrated circuit components may be coupled to the interposer 2604; indeed, additional interposers may be coupled to the interposer 2604. The interposer 2604 may provide an intervening substrate used to bridge the circuit board 2602 and the integrated circuit component 2620.

The integrated circuit component 2620 may be a packaged or unpacked integrated circuit product that includes one or more integrated circuit dies (e.g., the integrated circuit device 2500 of FIG. 25) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 2620, a single monolithic integrated circuit die comprises solder bumps attached to contacts on the die. The solder bumps allow the die to be directly attached to the interposer 2604. The integrated circuit component 2620 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 2620 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 2620 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 2620 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 2604 may spread connections to a wider pitch or reroute a connection to a different connection. For example, the interposer 2604 may couple the integrated circuit component 2620 to a set of ball grid array (BGA) conductive contacts of the coupling components 2616 for coupling to the circuit board 2602. In the embodiment illustrated in FIG. 26, the integrated circuit component 2620 and the circuit board 2602 are attached to opposing sides of the interposer 2604; in other embodiments, the integrated circuit component 2620 and the circuit board 2602 may be attached to a same side of the interposer 2604. In some embodiments, three or more components may be interconnected by way of the interposer 2604.

In some embodiments, the interposer 2604 may be formed as a PCB, including multiple metal layers separated from one another by layers of dielectric material and interconnected by electrically conductive vias. In some embodiments, the interposer 2604 may be formed of an epoxy resin, a fiberglass-reinforced epoxy resin, an epoxy resin with inorganic fillers, a ceramic material, or a polymer material such as polyimide. In some embodiments, the interposer 2604 may be formed of alternate rigid or flexible materials that may include the same materials described above for use in a semiconductor substrate, such as silicon, germanium, and other group III-V and group IV materials. The interposer 2604 may include metal interconnects 2608 and vias 2610, including but not limited to through hole vias 2610-1 (that extend from a first face 2650 of the interposer 2604 to a second face 2654 of the interposer 2604), blind vias 2610-2 (that extend from the first or second faces 2650 or 2654 of the interposer 2604 to an internal metal layer), and buried vias 2610-3 (that connect internal metal layers).

In some embodiments, the interposer 2604 can comprise a silicon interposer. Through silicon vias (TSV) extending through the silicon interposer can connect connections on a first face of a silicon interposer to an opposing second face of the silicon interposer. In some embodiments, an interposer 2604 comprising a silicon interposer can further comprise one or more routing layers to route connections on a first face of the interposer 2604 to an opposing second face of the interposer 2604.

The interposer 2604 may further include embedded devices 2614, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 2604. The package-on-interposer structure 2636 may take the form of any of the package-on-interposer structures known in the art. In embodiments where the interposer is a non-printed circuit board

The integrated circuit device assembly 2600 may include an integrated circuit component 2624 coupled to the first face 2640 of the circuit board 2602 by coupling components 2622. The coupling components 2622 may take the form of any of the embodiments discussed above with reference to the coupling components 2616, and the integrated circuit component 2624 may take the form of any of the embodiments discussed above with reference to the integrated circuit component 2620.

The integrated circuit device assembly 2600 illustrated in FIG. 26 includes a package-on-package structure 2634 coupled to the second face 2642 of the circuit board 2602 by coupling components 2628. The package-on-package structure 2634 may include an integrated circuit component 2626 and an integrated circuit component 2632 coupled together by coupling components 2630 such that the integrated circuit component 2626 is disposed between the circuit board 2602 and the integrated circuit component 2632. The coupling components 2628 and 2630 may take the form of any of the embodiments of the coupling components 2616 discussed above, and the integrated circuit components 2626 and 2632 may take the form of any of the embodiments of the integrated circuit component 2620 discussed above. The package-on-package structure 2634 may be configured in accordance with any of the package-on-package structures known in the art.

As used in this application and the claims, a list of items joined by the term "and/or" can mean any combination of the listed items. For example, the phrase "A, B and/or C" can mean A; B; C; A and B; A and C; B and C; or A, B and C. As used in this application and the claims, a list of items joined by the term "at least one of" can mean any combination of the listed terms. For example, the phrase "at least one of A, B, or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B, and C" can mean A; B; C; A and B; A and C; B and C; or **A,** B, and C.

As used in this application and the claims, the phrase "individual of" or "respective of" following by a list of items recited or stated as having a trait, feature, etc. means that all of the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect, feature, or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

The following examples pertain to additional embodiments of technologies disclosed herein. (This portion will be filled in upon inventor approval of the draft application.)

Example 1 is a system comprising: an alignment module to place a frame and one or more solid layers of glass on a carrier, wherein the one or more solid layers of glass are positioned within the frame with a gap located between the frame and the one or more solid layers of glass; a buffer lamination module to place a buffer layer on a portion of a surface of the frame and one or more surfaces of the one or more solid layers of glass, wherein the buffer layer covers the gap and comprises buffer material; a gap reinforcement module to place a plurality of reinforcement strips on the buffer layer, the plurality of reinforcement strips comprising reinforcement material, wherein the plurality of reinforcement strips cover the gap, wherein a hybrid panel assembly comprises the frame, the one or more solid layers of glass, and the plurality of reinforcement strips; and a press module to press the hybrid panel assembly in a mold to force a portion of the buffer material of the buffer layer into the gap, wherein the hybrid panel assembly, after being pressed, is a hybrid panel having substantially planar top and bottom surfaces.

Example 2 comprises the system of Example 1, wherein the plurality of reinforcement strips comprise a first layer comprising the reinforcement material and a second layer comprising the buffer material.

Example 3 comprises the system of Example 1 or 2, wherein to place the plurality of reinforcement strips on the buffer layer comprises to rotate the frame by ninety degrees between placement of individual reinforcement strips of the plurality of reinforcement strips on the buffer layer.

Example 4 comprises the system of any one of Examples 1-3, where the gap reinforcement module comprises a reinforcement material source, wherein to place the plurality of reinforcement strips on the buffer layer comprises, for individual reinforcement strips of the plurality of reinforcement strips: to cut the individual reinforcement strip from the reinforcement material source; to place the individual reinforcement strip on the buffer layer; and to trim the individual reinforcement strip.

Example 5 comprises the system of Example 4, wherein the reinforcement material source comprises a roll of reinforcement material.

Example 6 comprises the system of Example 4, wherein the reinforcement material source comprises a roll of material comprising a first layer comprising the reinforcement material and a second layer comprising the buffer material.

Example 7 comprises the system of any one of Examples 1-6, wherein the one or more solid layers of glass are a plurality of solid layers of glass and adjacent solid layers of glass are separated by a glass gap of a plurality of glass gaps, wherein the plurality of reinforcement strips further cover the plurality of glass gaps.

Example 8 comprises the system of any one of Examples 1-7, wherein the buffer layer is a first buffer layer, the surface of the frame is a first surface of the frame, the one or more surfaces of the one or more solid layers of glass are one or more first surfaces of the one or more solid layers of glass, the buffer lamination module to further place a second buffer layer on a portion of a second surface of the frame and one or more second surfaces of the one or more solid layers of glass, the frame and the one or more solid layers of glass positioned between the first buffer layer and the second buffer layer, wherein the second buffer layer comprises the buffer material, wherein the first surface of the frame is opposite the second surface of the frame and the one or more first surfaces of the one or more solid layers of glass are opposite to the one or more second surfaces of the one or more solid layers of glass.

Example 9 comprises the system of Example 8, the gap reinforcement module to further place a plurality of second reinforcement strips on the second buffer layer, the plurality of second reinforcement strips comprising covering the gap and comprising the reinforcement material.

Example 10 comprises the system of Example 9, wherein the buffer lamination module or the gap reinforcement module is to further flip the frame after the gap reinforcement module places the plurality of reinforcement strips on the first buffer layer and before the buffer lamination module places the second buffer layer on the frame and the one or more solid layers of glass.

Example 11 comprises the system of Example 9, wherein the plurality of second reinforcement strips comprise a first layer comprising the reinforcement material and a second layer comprising the buffer material.

Example 12 is a system comprising: an alignment module to place a frame and one or more solid layers of glass on a carrier, wherein the one or more solid layers of glass are positioned within the frame with a gap located between the frame and the one or more solid layers of glass; a buffer lamination module to place a buffer layer on a portion of a surface of the frame and one or more surfaces of the one or more solid layers of glass, wherein the buffer layer covers the gap and comprises buffer material; a gap reinforcement module to place a reinforcement layer on the buffer layer, wherein the reinforcement layer covers the gap and comprises reinforcement material, wherein a hybrid panel assembly comprises the frame, the one or more solid layers of glass, and the buffer layer; and a press module to press the hybrid panel assembly in a mold to force a portion of the buffer material of the buffer layer into the gap, wherein the hybrid panel assembly, after being pressed, is a hybrid panel having substantially planar top and bottom surfaces.

Example 13 comprises the system of Example 12, wherein the reinforcement layer comprises a first layer comprising the reinforcement material and a second layer comprising the buffer material.

Example 14 comprises the system of Example 12 or 13, wherein the one or more solid layers of glass are a plurality of solid layers of glass and adjacent solid layers of glass are separated by a glass gap of a plurality of glass gaps, the reinforcement layer further covering the plurality of glass gaps.

Example 15 comprises the system of any one of Examples 12-14, wherein the buffer layer is a first buffer layer, wherein the surface of the frame is a first surface of the frame and the one or more surfaces of the one or more solid layers of glass are one or more first surfaces of the one or more solid layers of glass, the buffer lamination module to further place a second buffer layer on a portion of a second surface of the frame and one or more second surfaces of the one or more solid layers of glass, the frame and the one or more solid layers of glass positioned between the first buffer layer and the second buffer layer, wherein the second buffer layer comprises the buffer material, wherein the first surface of the frame is opposite the second surface of the frame and the one or more first surfaces of the one or more solid layers of glass are opposite to the one or more second surfaces of the one or more solid layers of glass.

Example 16 comprises the system of Example 15, wherein the reinforcement layer is a first reinforcement layer, the gap reinforcement module to further place a second reinforcement layer on the second buffer layer, the second reinforcement layer comprising the reinforcement material and covering the gap.

Example 17 comprises the system of Example 16, wherein the buffer lamination module or the gap reinforcement module is to further flip the frame after the gap reinforcement module places the reinforcement layer on the first buffer layer and before the buffer lamination module places the second buffer layer on the frame and the one or more solid layers of glass.

Example 18 comprises the system of Example 16, wherein the second reinforcement layer comprises a first layer comprising the reinforcement material and a second layer comprising the buffer material.

Example 19 is a system comprising: an alignment module to place a frame and one or more solid layers of glass on a carrier, wherein the one or more solid layers of glass are positioned within the frame with a gap located between the frame and the one or more solid layers of glass; a buffer lamination module to place a first buffer layer on a portion of a first surface of the frame and one or more first surfaces of the one or more solid layers of glass, wherein the first buffer layer covers the gap and comprises buffer material; a gap reinforcement module to dispense liquid mold material along the gap, the buffer lamination module to, after the gap reinforcement module dispenses the liquid mold material, the buffer lamination module to further place a second buffer layer on a portion of a second surface of the frame and one or more second surfaces of the one or more solid layers of glass, the frame and the one or more solid layers of glass positioned between the first buffer layer and the second buffer layer, the first buffer layer and the second buffer layer comprising buffer material, wherein a hybrid panel assembly comprises the frame, the one or more solid layers of glass, wherein the first surface of the frame is opposite the second surface of the frame and the one or more first surfaces of the one or more solid layers of glass are opposite to the one or more second surfaces of the one or more solid layers of glass; and a press module to press the hybrid panel assembly in a mold to force a portion of the buffer material of the first buffer layer into the gap, wherein the hybrid panel assembly, after being pressed, is a hybrid panel having substantially planar top and bottom surfaces.

Example 20 comprises the system of any one of Examples 8-11 or 15-19, wherein a first outer face of the frame extends past an outer extent of the first buffer layer and an outer extent of the second buffer layer, wherein a second outer face of the frame extends past the outer extent of the first buffer layer and the outer extent of the second buffer layer, wherein the first outer face of the frame is located opposite to the second outer face of the frame.

Example 21 comprises the system of any one of Examples 1-20, further comprising: a loader to load the alignment module with the frame and the one or more solid layers of glass; and an unloader to unload the hybrid panel from the press module.

Example 22 comprises the system of any one of Examples 1-21, wherein the system is automated.

Example 23 is a gap reinforcement module comprising: a reinforcement material source comprising reinforcement material; a chuck to hold a hybrid panel assembly in place, the hybrid panel assembly comprising a frame and one or more solid layers of glass spaced from the frame by a gap, wherein the frame is rectangular in shape and the chuck is rotatable; a cutting mechanism to cut a reinforcement strip from the reinforcement material source; a placement mechanism to place the reinforcement strip over the gap along an inner edge of the frame; a trimming mechanism to trim the reinforcement strip after placement of the reinforcement strip on the hybrid panel assembly; a strip excess removal mechanism to remove reinforcement strip excess after the reinforcement strip is trimmed; and a controller to control the cutting mechanism, the placement mechanism, the trimming mechanism, the strip excess removal mechanism, and rotation of the chuck.

Example 24 comprises the gap reinforcement module of Example 23, the controller to further control the cutting mechanism, the placement mechanism, the trimming mechanism and rotation of the chuck to cause four reinforcement strips to be placed over the gap, the controller to cause the chuck to rotate between placement of reinforcement strips.

Example 25 comprises the gap reinforcement module of Example 23 or 24, wherein the reinforcement strip is a first reinforcement strip, one or more solid layers of glass are a plurality of solid layers of glass, adjacent solid layers of glass spaced by a glass gap, the placement mechanism to further place a second reinforcement strip along a glass gap.

Example 26 comprises the gap reinforcement module of Example 23-25, wherein the cutting mechanism comprises a knife.

Example 27 comprises the gap reinforcement module of Example 23-25, wherein the trimming mechanism comprises a knife.

Example 28 comprises the gap reinforcement module of Example 23-25, wherein the cutting mechanism and the trimming mechanism are the same mechanism.

Example 29 is a gap reinforcement module comprising: a reinforcement material source comprising reinforcement material; a chuck to hold a hybrid panel assembly in place, the hybrid panel assembly comprising a frame and one or more solid layers of glass spaced from the frame by a gap, wherein the frame is rectangular in shape; a dispenser to dispense liquid mold material along the gap; and a controller to control the dispenser.

Example 30 comprises the gap reinforcement module of Example 29, wherein the one or more solid layers of glass are a plurality of solid layers of glass, adjacent solid layers of glass spaced by a glass gap, the dispenser to further dispense liquid mold material along a glass gap.

Example 31 comprises the gap reinforcement module of any one of Examples 23-30, wherein the reinforcement material source comprises a roll of reinforcement material.

Example 32 comprises the gap reinforcement module of any one of Examples 23-31, wherein the reinforcement strip comprises a first layer comprising the reinforcement material and a second layer comprising buffer material.

Example 33 is a method comprising: placing a frame and one or more solid layers of glass on a carrier, the one or more solid layers of glass positioned within the frame, a gap located between the frame and the one or more solid layers of glass; placing a buffer layer on a portion of a surface of the frame and one or more surfaces of the one or more solid layers of glass, wherein the buffer layer covers the gap and comprises buffer material; placing a plurality of reinforcement strips on the buffer layer, the plurality of reinforcement strips comprising reinforcement material, wherein the plurality of reinforcement strips cover the gap, wherein a hybrid panel assembly comprises the frame, the one or more solid layers of glass, the buffer layer, and the plurality of reinforcement strips; and pressing the hybrid panel assembly in a mold to force a portion of the buffer material of the buffer layer into the gap, wherein the hybrid panel assembly, after being pressed, is a hybrid panel having substantially planar top and bottom surfaces.

Example 34 comprises the method of Example 33, wherein placing the frame and the one or more solid layers of glass on the carrier is performed by an alignment module, placing the buffer layer on the frame and the one or more solid layers of glass is performed by a buffer lamination module, placing the plurality of reinforcement strips on the buffer layer is performed by a gap reinforcement module, placing the buffer layer on the frame and the one or more solid layers of glass is performed by the buffer lamination module, and pressing the hybrid panel assembly in a mold buffer layer is performed by a press module.

Example 35 comprises the method of Example 33 or 34, wherein the plurality of reinforcement strips comprise a first layer comprising the reinforcement material and a second layer comprising the buffer material.

Example 36 comprises the method of any one of Examples 33-35, wherein placing the plurality of reinforcement strips on the buffer layer comprises rotating the frame by ninety degrees between placement of individual reinforcement strips of the plurality of reinforcement strips on the buffer layer.

Example 37 comprises the method of any one of Examples 33-36, wherein placing the plurality of reinforcement strips on the buffer layer comprises, for individual reinforcement strips of the plurality of reinforcement strips: cutting the individual reinforcement strip from a reinforcement material source; placing the individual reinforcement strip on the buffer layer; and trimming the individual reinforcement strip.

Example 38 comprises the method of Example 37, wherein the reinforcement material source comprises a roll of reinforcement material.

Example 39 comprises the method of Example 37, wherein the reinforcement material source comprises a roll of material comprising a first layer comprising the reinforcement material and a second layer comprising the buffer material.

Example 40 comprises the method of any one of Examples 33-39, wherein the one or more solid layers of glass are a plurality of solid layers of glass and adjacent solid layers of glass are separated by a glass gap of a plurality of glass gaps, wherein the plurality of reinforcement strips further cover the plurality of glass gaps.

Example 41 comprises the method of any one of Examples 33-40, wherein the buffer layer is a first buffer layer, the surface of the frame is a first surface of the frame, the one or more surfaces of the one or more solid layers of glass are one or more first surfaces of the one or more solid layers of glass, the method further comprising placing a second buffer layer on a portion of a second surface of the frame and one or more second surfaces of the one or more solid layers of glass, the frame and the one or more solid layers of glass positioned between the first buffer layer and the second buffer layer, wherein the second buffer layer comprises the buffer material, wherein the first surface of the frame is opposite to the second surface of the frame and the one or more first surfaces of the one or more solid layers of glass are opposite to the one or more second surfaces of the one or more solid layers of glass.

Example 42 comprises the method of Example 41, further comprising flipping the frame after placing the plurality of reinforcement strips on the first buffer layer and before placing the second buffer layer on the frame and the one or more solid layers of glass.

Example 43 comprises the method of Example 41 or 42, wherein the plurality of reinforcement strips are a first plurality of reinforcement strips, the method further comprising, after placing the second buffer layer on the portion of the second surface of the frame and one or more second surfaces of the one or more solid layers of glass, placing a second plurality of reinforcement strips on the second buffer layer, the second plurality of reinforcement strips comprising the reinforcement material, the second plurality of reinforcement strips covering the gap.

Example 44 comprises the method of Example 43, wherein the second plurality of reinforcement strips comprise a first layer comprising the reinforcement material and a second layer comprising the buffer material.

Example 45 is a method comprising: placing a frame and one or more solid layers of glass on a carrier, the one or more solid layers of glass positioned within the frame, a gap located between the frame and the one or more solid layers of glass; placing a buffer layer on a portion of a first surface of the frame and one or more first surfaces of the one or more solid layers of glass, wherein the buffer layer covers the gap and comprises buffer material; placing a reinforcement layer on the buffer layer, wherein the reinforcement layer covers the gap and comprises reinforcement material, wherein a hybrid panel assembly comprises the frame, the one or more solid layers of glass, and the buffer layer; and pressing, the hybrid panel assembly in a mold to force a portion of the buffer material of the buffer layer into the gap, wherein the hybrid panel assembly, after being pressed, is a hybrid panel having substantially planar top and bottom surfaces.

Example 46 comprises the method of Example 45, wherein placing the frame and the one or more solid layers of glass on the carrier is performed by an alignment module, placing the buffer layer on the frame and the one or more solid layers of glass is performed by a buffer lamination module, placing the reinforcement layer on the buffer layer is performed by a gap reinforcement module, placing the buffer layer on the frame and the one or more solid layers of glass is performed by the buffer lamination module, and pressing the hybrid panel assembly in a mold is performed by a press module.

Example 47 comprises the method of Example 45 or 46, wherein the reinforcement layer comprises a first layer comprising the reinforcement material and a second layer comprising the buffer material.

Example 48 comprises the method of any one of Examples 45-47, further comprising flipping the frame after placing the reinforcement layer on the buffer layer and placing a second buffer layer on the frame and the one or more solid layers of glass.

Example 49 comprises the method of any one of Examples 45-48, wherein the one or more solid layers of glass are a plurality of solid layers of glass and adjacent solid layers of glass are separated by a glass gap of a plurality of glass gaps, the reinforcement layer further covering the plurality of glass gaps.

Example 50 comprises the method of any one of Examples 45-49, where in the buffer layer is a first buffer layer, the method further comprising placing a second buffer layer on a portion of a second surface of the frame and one or more second surfaces of the one or more solid layers of glass, the frame and the one or more solid layers of glass positioned between the first buffer layer and the second buffer layer, wherein the second buffer layer comprises the buffer material, wherein the first surface of the frame is opposite to the second surface of the frame and the one or more first surfaces of the one or more solid layers of glass are opposite to the one or more second surfaces of the one or more solid layers of glass.

Example 51 comprises the method of Example 50, wherein the reinforcement layer is a first reinforcement layer, the method further comprising, after placing the second buffer layer on the frame and the one or more solid layers of glass, placing a second reinforcement layer on the second buffer layer, the second reinforcement layer comprising the reinforcement material and covering the gap.

Example 52 comprises the method of Example 50 or 51, wherein the reinforcement layer comprises a first layer comprising the reinforcement material and a second layer comprising the buffer material.

Example 53 is a method comprising: placing a frame and one or more solid layers of glass on a carrier, the one or more solid layers of glass positioned within the frame, a gap located between the frame the one or more solid layers of glass; placing a first buffer layer on a portion of a first surface of the frame and one or more first surfaces of the one or more solid layers of glass, wherein the first buffer layer covers the gap; dispensing liquid mold material along the gap; placing a second buffer layer on a portion of a second surface of the frame and one or more second surfaces of the one or more solid layers of glass, the frame and the one or more solid layers of glass positioned between the first buffer layer and the second buffer layer, wherein a hybrid panel assembly comprises the frame, the one or more solid layers of glass, wherein the first buffer layer and the second buffer layer comprise buffer material, wherein the first surface of the frame is opposite to the second surface of the frame and the one or more first surfaces of the one or more solid layers of glass are opposite to the one or more second surfaces of the one or more solid layers of glass; and pressing the hybrid panel assembly in a mold to force a portion of the buffer material of the first buffer layer into the gap, wherein the hybrid panel assembly, after being pressed, is a hybrid panel having substantially planar top and bottom surfaces.

Example 54 comprises the method of Example 53, wherein placing the frame and the one or more solid layers of glass on the carrier is performed by an alignment module, placing the first buffer layer on the portion of the frame and the one or more first surfaces of the one or more solid layers of glass is performed by a buffer lamination module, dispensing liquid mold material along the gap is performed by a gap reinforcement module; placing the second buffer layer on the portion of the second surface of the frame and one or more second surfaces of the one or more solid layers of glass is performed by the buffer lamination module, and pressing the hybrid panel assembly in the mold is performed by a press module.

Example 55 comprises the method of Example 53 or 54, further comprising flipping the frame after dispensing the liquid mold material and before placing the second buffer layer on the portion of the second surface of the frame and the one or more second surfaces of the one or more solid layers of glass.

Example 56 comprises the method of any one of Examples 53-55, wherein a first outer face of the frame extends past an outer extent of the first buffer layer and an outer extent of the second buffer layer, wherein a second outer face of the frame extends past the outer extent of the first buffer layer and the outer extent of the second buffer layer, wherein the first outer face of the frame is located opposite to the second outer face of the frame.

Example 57 comprises the method of any one of Examples 33-56, wherein the frame comprises a copper clad laminate.

Example 58 comprises the method of any one of Examples 33-56 wherein the frame comprises a frame material positioned between two layers of copper.

Example 59 comprises the method of any one of Examples 58, wherein the frame material comprises carbon and hydrogen.

Example 60 comprises the method of any one of Examples 33-59, wherein the reinforcement material comprises fibers comprising silicon and oxygen.

Example 61 comprises the method of any one of Examples 33-59, wherein the reinforcement material comprises a glass cloth prepreg material.

Example 62 comprises the method of any one of Examples 33-59, wherein the reinforcement material comprises a polymer resin.

Example 63 comprises the method of any one of Examples 33-62, wherein the buffer material comprises Ajinomoto Build-up film.

Example 64 comprises the method of any one of Examples 33-62, wherein the buffer material predominantly comprises carbon.

Example 65 comprises the method of any one of Examples 53-55, wherein the liquid mold material comprises: particles comprising silicon and oxygen; fibers comprising silicon and oxygen; or fibers comprising aluminum and oxygen.

Example 66 comprises the method of Example 53 or 54, wherein the liquid mold material comprises: carbon and oxygen; or carbon, hydrogen, and oxygen.

Example 67 comprises the method of any one of Examples 33-66, wherein the one or more solid layers of glass comprise: silicon and oxygen; silicon, oxygen, and aluminum; silicon, oxygen, and boron; and silicon, oxygen, aluminum, and boron.

Example 68 comprises the method of any one of Examples 33-66, wherein the one or more solid layers of glass comprise silicon, oxygen, and one or more of aluminum, boron, beryllium, magnesium, calcium, barium, tin, sodium, potassium, strontium, phosphorous, zirconium, lithium, titanium, and zinc.

Example 69 comprises the method of any one of Examples 33-68, wherein the gap has a width in a range of about five millimeters to about 15 millimeters.

Example 70 comprises the method of any one of Examples 33-69, wherein an outer extent of the one or more solid layers of glass has a first length in a range of about 10 millimeters to about 250 millimeters and a second length in a range of about 10 millimeters to about 250 millimeters, the first length perpendicular to the second length.

Example 71 comprises the method of any one of Examples 33-69, wherein an outer extent of the one or more solid layers of glass has a first length of about 600 millimeters or less and a second length in a range of about 600 millimeters or less, the first length perpendicular to the second length.

Example 72 comprises the method of any one of Examples 34, 46, or 54, the method further comprising: transporting the frame and the one or more solid layers of glass from the alignment module to the buffer lamination module; transporting the frame and the one or more solid layers of glass from the buffer lamination module to the gap reinforcement module; and transporting the frame and the one or more solid layers of glass from the gap reinforcement module to the press module.

Example 73 comprises the method of Example 72, further comprising: receiving, at a loader, the frame and the one or more solid layers of glass; loading the alignment module with the frame and one or more solid layers of glass; and unloading, by an unloader, the hybrid panel from the press module.

Example 74 comprises the method of any one of Examples 33-73, wherein the method is automated.

Example 75. One or more computer-readable storage media storing computer-executable instructions that, when executed, cause a tool link to perform any one of the methods of Examples 33-74.

Example 76. An apparatus comprising: a frame having a rectangular shape; a solid layer of glass located within the frame, the solid layer of glass having a rectangular shape in plan view, the frame separated from the solid layer of glass by a gap substantially filled with gap fill material; and a layer comprising a material, wherein the layer is located on the solid layer of glass and is located on a portion of the frame, wherein the layer covers the gap and is substantially planar.

Example 77 comprises the apparatus of Example 76, wherein a top surface of the frame is coplanar with a top surface of the solid layer of glass.

Example 78 comprises the apparatus of Example 76, wherein the layer is a first layer, the apparatus further comprising a second layer comprising the material, the solid layer of glass positioned between the first layer and the second layer, wherein the second layer is located on the solid layer of glass and is located on a portion of the frame, wherein the second layer covers the gap and is substantially planar.

Example 79 comprises the apparatus of Example 78, wherein a first outer face of the frame extends past an outer extent of the first layer and an outer extent of the second layer, wherein a second outer face of the frame extends past the outer extent of the first layer and the outer extent of the second layer, wherein the first outer face of the frame is located opposite to the second outer face of the frame.

Example 80 comprises the apparatus of any one of Example 76-79, wherein the frame comprises a copper clad laminate.

Example 81 comprises the apparatus of any one of Example 76-79, wherein the frame comprises a frame material positioned between two layers of copper.

Example 82 comprises the apparatus of Example 81, wherein the frame material comprises carbon and hydrogen.

Example 83 comprises the apparatus of any one of Example 76-82, wherein the gap fill material comprises Ajinomoto Build-up film.

Example 84 comprises the apparatus of any one of Example 76-83, wherein the gap fill material predominantly comprises carbon.

Example 85 comprises the apparatus of Example 76 or 83-84, wherein the gap fill material comprises: particles comprising silicon and oxygen; fibers comprising silicon and oxygen; or fibers comprising silicon, oxygen, and aluminum.

Example 86 comprises the apparatus of Example 76 or 83-84, wherein the gap fill material comprises: carbon and oxygen; or carbon, hydrogen, and oxygen.

Example 87 comprises the apparatus of any one of Example 76-86, wherein the material comprises fibers comprising silicon and oxygen.

Example 88 comprises the apparatus of any one of Example 76-86, wherein the material comprises a glass cloth prepreg material.

Example 89 comprises the apparatus of any one of Example 76-86, wherein the material comprises a polymer resin.

Example 90 comprises the apparatus of any one of Example 87-89, wherein the layer is a first layer, the apparatus further comprising a second layer comprising the material, the solid layer of glass positioned between the first layer and the second layer, wherein the second layer covers the gap, is located on the solid layer of glass, and is located on a portion of the frame, wherein the second layer is substantially planar.

Example 91 comprises the apparatus of any one of Example 76-86, wherein a portion of the layer covers the gap, overlaps a first top edge where the gap meets the frame, and overlaps a second top edge where the gap meets the layer, the material comprising fibers comprising silicon and oxygen.

Example 92 comprises the apparatus of any one of Example 76-86, wherein a portion of the layer covers the gap, overlaps a first top edge where the gap meets the frame, and overlaps a second top edge where the gap meets the layer, the material comprising a glass cloth prepreg material.

Example 93 comprises the apparatus of any one of Example 76-86, wherein a portion of the layer covers the gap, overlaps a first top edge where the gap meets the frame, and overlaps a second top edge where the gap meets the layer, the material comprising a polymer resin.

Example 94 comprises the apparatus of any one of Example 91-93, wherein the layer is a first layer, the apparatus further comprising a second layer comprising the material, the solid layer of glass positioned between the first layer and the second layer, wherein the second layer covers the gap, is located on the solid layer of glass, and is located on a portion of the frame, wherein the second layer is substantially planar, wherein a portion of the second layer covers the gap, overlaps a first bottom edge where the gap meets the frame, and overlaps a second bottom edge where the gap meets the solid layer of glass.

Example 95 comprises the apparatus of any one of Example 91-93, wherein the portion of the layer is a first portion, and a second portion of the layer covers a portion of the solid layer of glass, the second portion of the layer comprising Ajinomoto Build-up Film.

Example 96 comprises the apparatus of any one of Examples 91-93, wherein the portion of the layer is a first portion, and a second portion of the layer covers a portion of the solid layer of glass, the second portion of the layer predominantly comprising carbon.

Example 97 comprises the apparatus of any one of Example 95-96, wherein the layer is a first layer, the apparatus further comprising a second layer comprising the material, the solid layer of glass positioned between the first layer and the second layer, wherein the second layer covers the gap, is located on the solid layer of glass, and is located on the portion of the frame, wherein the second layer is substantially planar, wherein a first portion of the second layer covers the gap, overlaps a first bottom edge where the gap meets the frame, and overlaps a second bottom edge where the gap meets the solid layer of glass, wherein a second portion of the second layer covers the portion of the solid layer of glass, the second portion of the second layer comprising Ajinomoto Build-up Film or predominantly comprising carbon.

Example 98 comprises the apparatus of Example 76 or 85-86, wherein the material predominantly comprises Ajinomoto Build-up film.

Example 99 comprises the apparatus of Example 76 or 85-86, wherein the material predominantly comprises carbon.

Example 100 comprises the apparatus of Example 98 or 99, wherein the layer is a first layer, the apparatus further comprising a second layer comprising the material, the solid layer of glass positioned between the first layer and the second layer, wherein the second layer covers the gap, is located on the solid layer of glass, and is located on a portion of the frame, wherein the second layer is substantially planar.

Example 101 comprises the apparatus of any one of Example 76-100, wherein the solid layer of glass is a first solid layer of glass and the gap is a first gap, wherein the apparatus further comprises a plurality of second solid layers of glass, the layer located on at least a portion of the individual second solid layers of glass of the plurality of second solid layers of glass, wherein a top surface of individual of the second solid layers of glass of the plurality of second solid layers of glass and a top surface of the first solid layer of glass are coplanar, the plurality of second solid layers of glass located within the frame, adjacent second layers of glass of the plurality of second solid layers of glass separated by a glass gap of the plurality of glass gaps, individual of the glass gaps substantially filled with the gap fill material, individual of the second solid layers of glass having a rectangular shape in plan view.

Example 102 comprises the apparatus of Example 101, wherein the layer comprises a plurality of glass gap portions, wherein individual glass gap portions of the plurality of glass gap portions covers a glass gap of the plurality of glass gaps and extends over a portion of second layers of glass adjacent to the glass gap, the plurality of glass gap portions comprising fibers comprising silicon and oxygen.

Example 103 comprises the apparatus of Example 101, wherein the layer comprises a plurality of glass gap portions, wherein individual glass gap portions of the plurality of glass gap portions covers a glass gap of the plurality of glass gaps and extends over a portion of second layers of glass adjacent to the glass gap, the plurality of glass gap portions comprising a glass cloth prepreg material.

Example 104 comprises the apparatus of Example 101, wherein the layer comprises a plurality of glass gap portions, wherein individual glass gap portions of the plurality of glass gap portions covers a glass gap of the plurality of glass gaps and extends over a portion of second layers of glass adjacent to the glass gap, the plurality of glass gap portions comprising a polymer resin.

Example 105 comprises the apparatus of any one of Example 76-104, wherein the solid layer of glass has a thickness in a range of about 50 microns to about 1.4 millimeters.

Example 106 comprises the apparatus of any one of Example 76-105, wherein a width of the frame is in a range of about five to about 15 millimeters.

Example 107 comprises the apparatus of any one of Example 76-106, wherein a width of the gap is in a range of about 0.5 to about 10 millimeters.

Example 108 comprises the apparatus of any one of Example 76-107, wherein the glass comprises: silicon and oxygen; silicon, oxygen, and aluminum; silicon, oxygen, and boron; and silicon, oxygen, aluminum, and boron.

Example 109 comprises the apparatus of any one of Example 76-107, wherein the glass comprises silicon, oxygen, and one or more of aluminum, boron, magnesium, calcium, barium, tin, sodium, potassium, strontium, phosphorous, zirconium, lithium, titanium, and zinc.

Example 110 comprises the apparatus of any one of Example 76-108, wherein the glass comprises at least 23 percent silicon and at least 26 percent oxygen by weight.

Example 111 comprises the apparatus of Example 110, wherein the glass further comprises at least five percent aluminum by weight.

Example 112 comprises the apparatus of any one of Examples 76-111, wherein the solid layer of glass does not comprise an organic adhesive or an organic material.

Example 113 comprises the apparatus of any one of Examples 76-112, wherein the solid layer of glass is amorphous.

Example 114 comprises the apparatus of any one of Examples 76-113, wherein the solid layer of glass comprises a rectangular prism volume.

Example 115 comprises the apparatus of any one of Examples 76-114, wherein the solid layer of glass has a first length in a range of about 10 millimeters to about 250 millimeters and a second length in a range of about 10 millimeters to about 250 millimeters, the first length perpendicular to the second length.

Example 116 comprises the apparatus of any one of Examples 76-114, wherein the glass has a first length of about 600 millimeters or less and a second length in a range of about 600 millimeters or less, the first length perpendicular to the second length.

Example 117 comprises the method of any one of Examples 33-66, wherein the one or more solid layers of glass comprise silicon and at least one other element.

Example 118 comprises the apparatus of any one of Examples 76-107, wherein the glass comprises silicon and at least one other element.

Example 119 comprises the system of any one of Examples 1-22, wherein the press module constrains expansion of the frame during pressing of the hybrid panel assembly.

Example 120 comprises the system of Example 119, wherein the press module comprises a jig in which the frame is positioned during pressing of the hybrid panel assembly, the jig to constrain expansion of the frame during pressing of the hybrid panel assembly.

## Claims

1. A system comprising:
an alignment module to place a frame and one or more solid layers of glass on a carrier, wherein the one or more solid layers of glass are positioned within the frame with a gap located between the frame and the one or more solid layers of glass;
a buffer lamination module to place a buffer layer on a portion of a surface of the frame and one or more surfaces of the one or more solid layers of glass, wherein the buffer layer covers the gap and comprises buffer material;
a gap reinforcement module to place a plurality of reinforcement strips on the buffer layer, the plurality of reinforcement strips comprising reinforcement material, wherein the plurality of reinforcement strips covers the gap, wherein a hybrid panel assembly comprises the frame, the one or more solid layers of glass, and the plurality of reinforcement strips; and
a press module to press the hybrid panel assembly in a mold to force a portion of the buffer material of the buffer layer into the gap, wherein the hybrid panel assembly, after being pressed, is a hybrid panel having substantially planar top and bottom surfaces.

2. The system of claim 1, wherein the one or more solid layers of glass are a plurality of solid layers of glass and adjacent solid layers of glass are separated by a glass gap of a plurality of glass gaps, wherein the plurality of reinforcement strips further covers the plurality of glass gaps.

3. The system of claim 1 or 2, wherein the buffer layer is a first buffer layer, the surface of the frame is a first surface of the frame, the one or more surfaces of the one or more solid layers of glass are one or more first surfaces of the one or more solid layers of glass, the buffer lamination module to further place a second buffer layer on a portion of a second surface of the frame and one or more second surfaces of the one or more solid layers of glass, the frame and the one or more solid layers of glass positioned between the first buffer layer and the second buffer layer, wherein the second buffer layer comprises the buffer material, wherein the first surface of the frame is opposite the second surface of the frame and the one or more first surfaces of the one or more solid layers of glass are opposite to the one or more second surfaces of the one or more solid layers of glass.

4. The system of claim 3, wherein the plurality of reinforcement strips is a first plurality of reinforcement strips, the gap reinforcement module to further place a plurality of second reinforcement strips on the second buffer layer, the plurality of second reinforcement strips comprising covering the gap and comprising the reinforcement material.

5. The system of claim 4, wherein the buffer lamination module or the gap reinforcement module is to further flip the frame after the gap reinforcement module places the first plurality of reinforcement strips on the first buffer layer and before the buffer lamination module places the second buffer layer on the frame and the one or more solid layers of glass.

6. The system of claim 1 or 2, wherein the plurality of reinforcement strips comprises a first layer comprising the reinforcement material and a second layer comprising the buffer material.

7. A method comprising:
placing a frame and one or more solid layers of glass on a carrier, the one or more solid layers of glass positioned within the frame, a gap located between the frame and the one or more solid layers of glass;
placing a buffer layer on a portion of a surface of the frame and one or more surfaces of the one or more solid layers of glass, wherein the buffer layer covers the gap and comprises buffer material;
placing a plurality of reinforcement strips on the buffer layer, the plurality of reinforcement strips comprising reinforcement material, wherein the plurality of reinforcement strips covers the gap, wherein a hybrid panel assembly comprises the frame, the one or more solid layers of glass, the buffer layer, and the plurality of reinforcement strips; and
pressing the hybrid panel assembly in a mold to force a portion of the buffer material of the buffer layer into the gap, wherein the hybrid panel assembly, after being pressed, is a hybrid panel having substantially planar top and bottom surfaces.

8. The method of claim 7, wherein placing the frame and the one or more solid layers of glass on the carrier is performed by an alignment module, placing the buffer layer on the frame and the one or more solid layers of glass is performed by a buffer lamination module, placing the plurality of reinforcement strips on the buffer layer is performed by a gap reinforcement module, placing the buffer layer on the frame and the one or more solid layers of glass is performed by the buffer lamination module, and pressing the hybrid panel assembly in a mold buffer layer is performed by a press module.

9. The method of claim 7 or 8, wherein the one or more solid layers of glass are a plurality of solid layers of glass and adjacent solid layers of glass are separated by a glass gap of a plurality of glass gaps, wherein the plurality of reinforcement strips further covers the plurality of glass gaps.

10. The method of any one of claims 7-9, wherein the buffer layer is a first buffer layer, the surface of the frame is a first surface of the frame, the one or more surfaces of the one or more solid layers of glass are one or more first surfaces of the one or more solid layers of glass, the method further comprising placing a second buffer layer on a portion of a second surface of the frame and one or more second surfaces of the one or more solid layers of glass, the frame and the one or more solid layers of glass positioned between the first buffer layer and the second buffer layer, wherein the second buffer layer comprises the buffer material, wherein the first surface of the frame is opposite to the second surface of the frame and the one or more first surfaces of the one or more solid layers of glass are opposite to the one or more second surfaces of the one or more solid layers of glass.

11. The method of claim 10, wherein the plurality of reinforcement strips are a first plurality of reinforcement strips, the method further comprising, after placing the second buffer layer on the portion of the second surface of the frame and one or more second surfaces of the one or more solid layers of glass, placing a second plurality of reinforcement strips on the second buffer layer, the second plurality of reinforcement strips comprising the reinforcement material, the second plurality of reinforcement strips covering the gap.

12. The method of any one of claims 7-10, wherein the plurality of reinforcement strips comprises a first layer comprising the reinforcement material and a second layer comprising the buffer material.

13. The method of any one of claims 7-9, wherein placing the plurality of reinforcement strips on the buffer layer comprises, for individual reinforcement strips of the plurality of reinforcement strips:
cutting the individual reinforcement strip from a reinforcement material source;
placing the individual reinforcement strip on the buffer layer; and
trimming the individual reinforcement strip.

14. One or more computer-readable storage media storing computer-executable instructions that, when executed, cause a tool link to perform a method of any one of claims 7-13.

15. The system of any one of claims 1-6 or the method of any one of claims 7-13, wherein the glass comprises:
silicon and oxygen;
silicon, oxygen, and aluminum;
silicon, oxygen, and boron; and
silicon, oxygen, aluminum, and boron.
